(19) Europäisches Patentamt
European Patent Office
Office européen des brevets

(11) **EP 4 622 419 A1**

(12) **EUROPEAN PATENT APPLICATION**

(43) Date of publication:
24.09.2025 Bulletin 2025/39

(21) Application number: 25154608.1

(22) Date of filing: 29.01.2025

(51) International Patent Classification (IPC):
**H10D 84/80** (2025.01) **H10D 30/47** (2025.01)
**H10D 1/40** (2025.01) H10D 64/23 (2025.01)
H10D 62/17 (2025.01) H10D 62/85 (2025.01)

(52) Cooperative Patent Classification (CPC):
**H10D 30/475; H10D 1/40; H10D 84/01;**
**H10D 84/05; H10D 84/811; H10D 84/817;**
**H10D 84/82;** H10D 62/343; H10D 62/8503;
H10D 64/256

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: 21.03.2024 KR 20240039289

(71) Applicant: Samsung Electronics Co., Ltd.
Suwon-si, Gyeonggi-do 16677 (KR)

(72) Inventors:
• **KIM, Jin-Hwan**
**16677 Suwon-si, Gyeonggi-do (KR)**
• **HWANG, In Jun**
**16677 Suwon-si, Gyeonggi-do (KR)**

(74) Representative: **Kuhnen & Wacker**
**Patent- und Rechtsanwaltsbüro PartG mbB**
**Prinz-Ludwig-Straße 40A**
**85354 Freising (DE)**

(54) **SEMICONDUCTOR DEVICE**

(57) A semiconductor device, according to an embodiment, includes a main transistor (100), a sub transistor (310) that is connected to one terminal of the main transistor (100), and a resistive element (320) that is connected between another terminal of the main transistor (100) and the sub transistor (310). The main transistor (100) includes a main channel layer and a barrier layer, which is positioned on the main channel layer and contains a material having an energy band gap different from that of the main channel layer. The sub transistor (310) includes a first sub drift region having a first 2-dimensional electron gas, 2DEG, region. The resistive element (320) includes a channel pattern that is electrically connected between a sensing electrode (SE) of the sub transistor (310) and a main source electrode of the main transistor (100), and the channel pattern includes a second sub drift region having a second 2DEG region.

FIG. 1

EP 4 622 419 A1

**Description**

BACKGROUND OF THE INVENTION

**1. Field of the Invention**

The present disclosure relates to a semiconductor device.

**2. Description of the Related Art**

In modern society, semiconductor devices are closely related to our daily lives. In particular, power semiconductor devices are becoming increasingly important in various fields such as the transportation field, for example, electric vehicles, trains, and electric trams, renewable energy systems, for example, solar power generation and wind power generation, and mobile devices. Power semiconductor devices are semiconductor devices usable to handle high voltage or high current, and perform functions such as power conversion and control in large power systems and high-power electronic devices. Power semiconductor devices have the ability and durability to handle high power, allowing them to handle large amounts of current and withstand high voltages. For example, power semiconductor devices can handle voltages of hundreds to thousands of volts and currents of tens to thousands of amperes. Power semiconductor devices can improve the efficiency of electrical energy by minimizing power losses. Further, power semiconductor devices can be stably driven in environments such as high temperatures.

These power semiconductor devices can be categorized by their materials, and for example, there are SiC power semiconductor devices and GaN power semiconductor devices. Instead of conventional silicon (Si) wafers, SiC or GaN may be used to manufacture power semiconductor devices, whereby it is possible to compensate for the disadvantages of silicon having unstable characteristics at high temperatures. SiC power semiconductor devices are resistant to high temperatures and have low power loss, making them suitable for electric vehicles, renewable energy systems, and the like. GaN power semiconductor devices can involve high costs, but are efficient in terms of speed, making them suitable for fast charging of mobile devices and the like.

SUMMARY OF THE INVENTION

The present disclosure attempts to provide a semiconductor device that has stable electrical characteristics and improved reliability.

A semiconductor device according to an embodiment includes a main transistor, a sub transistor that is connected to one terminal of the main transistor, and a resistive element that is connected between another terminal of the main transistor and the sub transistor, where the semiconductor device includes a channel layer, where the main transistor includes a main channel layer comprising a first portion of the channel layer of the semiconductor device, a barrier layer that is positioned on the main channel layer and contains a material having an energy band gap different from an energy band gap of the main channel layer, a main gate electrode that is positioned on the barrier layer, a gate semiconductor layer that is positioned between the barrier layer and the main gate electrode, and a main source electrode and a main drain electrode that are positioned on opposite sides of the main gate electrode and are connected to the main channel layer, the sub transistor includes a sub channel layer comprising a second portion of the channel layer of the semiconductor device, where the sub channel layer includes a first sub drift region having a first 2-dimensional electron gas (2DEG) region, a sub drain electrode that is connected to the sub channel layer and extends from one end of the main drain electrode, a sub gate electrode that is positioned on the sub channel layer, and a sensing electrode that is positioned on the sub channel layer and is positioned on one side of the sub gate electrode, where a width of the sub channel layer is different from a width of the main channel layer, and the resistive element includes a channel pattern comprising a third portion of the channel layer of the semiconductor device, where the resistive element is electrically connected between the sensing electrode and the main source electrode and includes a second sub drift region having a second 2DEG region.

A semiconductor device according to an embodiment includes a main transistor, a sub transistor that is connected to one terminal of the main transistor, and a resistive element that is connected between another terminal of the main transistor and the sub transistor, where the semiconductor device includes a channel layer, where the main transistor includes a main channel layer comprising a first portion of the channel layer of the semiconductor device, a barrier layer that is positioned on the main channel layer and contains a material having an energy band gap different from an energy band gap of the main channel layer, a main gate electrode that is positioned on the barrier layer, a gate semiconductor layer that is positioned between the barrier layer and the main gate electrode, and a main source electrode and a main drain electrode that are positioned on opposite sides of the main gate electrode and are connected to the main channel layer, the sub transistor includes a sub channel layer comprising a second portion of the channel layer of the semiconductor device, where the sub channel layer includes a first sub drift region having a first 2DEG region, a sub drain electrode that is connected to the sub channel layer and extends from one end of the main drain electrode, a sub gate electrode that is positioned on the sub channel layer, and a sensing electrode that is positioned on the sub channel layer and is positioned on one side of the sub gate electrode, and the resistive element includes a channel pattern comprising a third portion of the channel layer of the semiconductor device, where the resistive element is positioned between the sensing electrode and the main source electrode and includes a second sub drift region having a second 2DEG region, and a length of the channel pattern between the sensing electrode and the main source electrode is 1 μm to 10 μm.

A semiconductor device according to an embodiment includes a main transistor, a sub transistor that is connected to one terminal of the main transistor, and a resistive element that is connected between another terminal of the main transistor and the sub transistor, where the semiconductor device includes a channel layer, where the main transistor includes a main channel layer comprising a first portion of the channel layer of the semiconductor device, wherein the main channel layer contains GaN, a barrier layer that is positioned on the main channel layer and contains AlGaN, a main gate electrode that is positioned on the barrier layer, a gate semiconductor layer that is positioned between the barrier layer and the main gate electrode and contains GaN doped with a p-type impurity, and a main source electrode and a main drain electrode that are positioned on opposite sides of the main gate electrode and are connected to the main channel layer, the sub transistor includes a sub channel layer comprising a second portion of the channel layer of the semiconductor device, wherein the sub channel layer is formed of the same material as the main channel layer and includes a first sub drift region having a first 2DEG region, a sub drain electrode that is connected to the sub channel layer and extends from one end of the main drain electrode, a sub gate electrode that is positioned on the sub channel layer, and a sensing electrode that is positioned on the sub channel layer and is positioned on one side of the sub gate electrode, where a width of the sub channel layer is different from a width of the main channel layer, and the resistive element includes a channel pattern comprising a third portion of the channel layer of the semiconductor device, where the channel pattern contains the same material as the main channel layer, is positioned between the sensing electrode and the main source electrode, and includes a second sub drift region having a second 2DEG region, where a resistance of the second sub drift region has a positive temperature coefficient of resistance, and where a first contact resistance between the sensing electrode and the channel pattern and a second contact resistance between the main source electrode and the channel pattern have negative temperature coefficients of resistance, and a sum of the resistance of the second sub drift region, the first contact resistance, and the second contact resistance is substantially constant regardless of temperature.

According to the embodiments, it is possible to improve the electrical characteristics and reliability of the semiconductor devices.

## BRIEF DESCRIPTION OF THE DRAWINGS

FIG. 1 is a circuit diagram illustrating a semiconductor device according to some embodiments.
FIG. 2 is a plan view illustrating the semiconductor device according to some embodiments.
FIGS. 3 and 4 are cross-sectional views taken along line A-A' of FIG. 2.
FIG. 5 is a plan view illustrating a peripheral circuit area of the semiconductor device according to some embodiments.
FIG. 6 is a cross-sectional view taken along line B-B' of FIG. 2.
FIG. 7 is a cross-sectional view taken along line C-C' of FIG. 2.
FIG. 8 is a cross-sectional view taken along line D-D' of FIG. 2.
FIG. 9 is a cross-sectional view which illustrates a semiconductor device according to some embodiments and corresponds to line D-D' of FIG. 2.
FIG. 10 is a circuit diagram illustrating a resistive element of the semiconductor device according to some embodiments.
FIG. 11 is a graph illustrating the resistance value of the resistive element of the semiconductor device according to some embodiments as temperature changes.
FIGS. 12 to 19 are plan views illustrating peripheral circuit elements of semiconductor devices according to some embodiments.
FIG. 20 is a circuit diagram illustrating a resistive element of a semiconductor device according to some embodiments.
FIG. 21 is a plan view illustrating a peripheral circuit element including the resistive element of FIG. 20.
FIG. 22 is a cross-sectional view taken along line E-E' of FIG. 20.
FIG. 23 is a plan view illustrating a peripheral circuit element including the resistive element of FIG. 20.
FIG. 24 is a cross-sectional view taken along line F-F' of FIG. 23.
FIG. 25 is a circuit diagram illustrating a resistive element of a semiconductor device according to some embodiments.
FIG. 26 is a plan view illustrating a peripheral circuit element including the resistive element of FIG. 25.
FIG. 27 is an enlarged plan view illustrating the resistive element of FIG. 26.
FIG. 28 is a cross-sectional view taken along line G-G' of FIG. 27.

FIG. 29 is a cross-sectional view which illustrates a resistive element of a semiconductor device according to some embodiments and corresponds to line G-G' of FIG. 27.

FIG. 30 is a plan view illustrating a resistive element of a semiconductor devices according to some embodiments.

FIG. 31 is a circuit diagram illustrating a resistive element of a semiconductor device according to some embodiments.

FIG. 32 is an enlarged plan view illustrating the resistive element of FIG. 31.

FIG. 33 is a circuit diagram illustrating a resistive element of a semiconductor device according to some embodiments.

FIG. 34 is an enlarged plan view illustrating the resistive element of FIG. 32.

FIG. 35 is a circuit diagram illustrating a semiconductor device according to some embodiments.

FIG. 36 is a plan view illustrating the semiconductor device of FIG. 35 according to some embodiments.

## DETAILED DESCRIPTION OF THE EMBODIMENTS

In the following detailed description, various example embodiments are shown and described, simply by way of illustration. The present invention can be variously implemented and is not limited to the following embodiments.

The drawings and description are to be regarded as illustrative in nature and not restrictive. Like reference numerals designate like elements throughout the specification. It should also be emphasized that the disclosure provides details of alternative examples, but such listing of alternatives is not exhaustive. Furthermore, any consistency of detail between various examples should not be interpreted as requiring such detail - it is impracticable to list every possible variation for every feature described herein. The language of the claims should be referenced in determining the requirements of the invention.

The size and thickness of each configuration shown in the drawings may be arbitrarily shown for understanding and ease of description, but the present invention is not limited thereto. In the drawings, the thickness of layers, films, panels, regions, etc., are exaggerated for clarity. Further, in the drawings, for understanding and ease of description, the thickness of some layers and areas is exaggerated.

It will be understood that when an element such as a layer, film, region, or substrate is referred to as being "on" another element, it can be directly on the other element or intervening elements may also be present. In contrast, when an element is referred to as being "directly on" another element, there are no intervening elements present (at least at the point of contact). Further, when an element is "on" a reference portion, the element is located above or below the reference portion, and it does not necessarily mean that the element is located "above" or "on" in a direction opposite to gravity.

Throughout the specification, when a component is described as "including" or "containing" a particular element or group of elements, it is to be understood that either the component is formed of only the element or the group of elements, or the element or group of elements may be combined with additional elements to form the component, unless the context indicates otherwise. The term "consisting of," on the other hand, indicates that a component is formed only of the element(s) listed. Unless explicitly described to the contrary, the word "comprise", and variations such as "comprises" or "comprising", will be understood to imply the inclusion of stated elements but not the exclusion of any other elements. Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

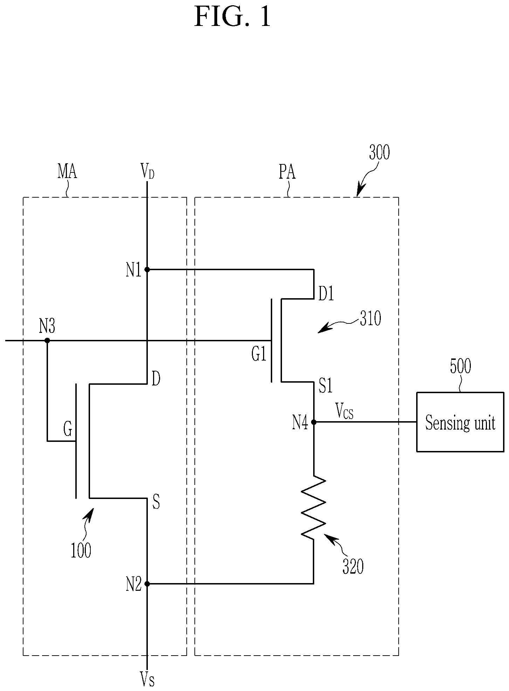

FIG. 1 is a circuit diagram illustrating a semiconductor device according to some embodiments.

As shown in FIG. 1, a semiconductor device according to an embodiment may include a main element area MA that includes a main transistor 100, a peripheral circuit area PA that includes a peripheral circuit element 300, and a sensing unit 500.

The main element area MA may be an area of the semiconductor device in which the main transistor 100 is disposed. In some examples, the main transistor 100 may be a normally-off high electron mobility transistor (HEMT). However, the main transistor 100 is not limited thereto, and may be a normally-on high electron mobility transistor in some embodiments.

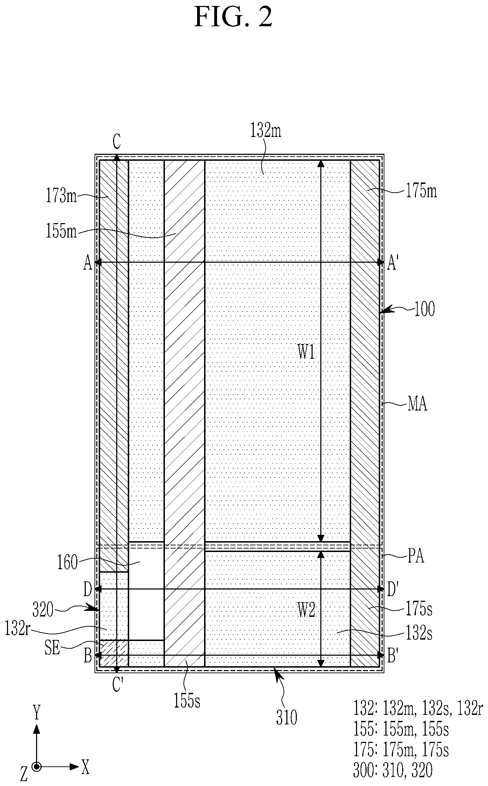

The main transistor 100 may include a gate electrode G, a drain electrode D, and a source electrode S. The main transistor 100 may control drain-source current between the drain electrode D and the source electrode S according to a gate signal which is applied to the gate electrode G. For example, when a turn-on signal is applied to the gate electrode G of the main transistor 100, current may flow from the drain electrode D to the source electrode S. Accordingly, current may flow from a node N1 to a node N2 through the main transistor 100. To the drain electrode D, a power voltage $V_D$ may be supplied, and to the source electrode S, a power voltage Vs may be supplied. The magnitude of the power voltage Vs may be smaller than the magnitude of the power voltage $V_D$. For example, the power voltage Vs may be a ground voltage (a reference voltage). The drain electrode D may correspond to the main drain electrode 175m of the main transistor 100 in FIG. 2, and the power voltage $V_D$ may be supplied to the main drain electrode 175m. The source electrode S may correspond to the main source electrode 173m of the main transistor 100 in FIG. 2, and the power voltage Vs may be supplied to the main source electrode (reference symbol "173m" in FIG. 2) of the main transistor 100

The peripheral circuit area PA may be an area of the semiconductor device in which a peripheral circuit element 300 is disposed. The peripheral circuit element 300 may include a sub transistor 310 which is electrically connected to one terminal of the main transistor 100, and a resistive element 320 which is electrically connected between another terminal of the main transistor 100 and the sub transistor 310. In some embodiments, the peripheral circuit element 300 may be a circuit forming a current divider. However, the peripheral circuit element 300 is not limited thereto, and for example, it may include passive elements such as capacitors, inductors, and the like, and/or may include active elements such as transistors, diodes, logic gates and the like. In some examples, the peripheral circuit element 300 may include a circuit forming a voltage divider, a voltage clipper, a protection element for the main transistor 100, etc. In the embodiment, the peripheral circuit area PA may refer to an area where the peripheral circuit element 300 is disposed.

Hereinafter, the case where the peripheral circuit element 300 of the semiconductor device according to the embodiment includes the sub transistor 310 and the resistive element 320 will be described.

The sub transistor 310 may include a gate electrode G1, a drain electrode D1, and a source electrode S1. The sub transistor 310 may control drain-source current between the drain electrode D1 and the source electrode S1 according to a gate signal which is applied to the gate electrode G1. For example, when a turn-on signal is applied to the gate electrode G1 of the sub transistor 310, current may flow from the drain electrode D1 to the source electrode S1.

The sub transistor 310 may be electrically connected to one terminal of the main transistor 100. The sub transistor 310 may be electrically connected between the resistive element 320 and the main transistor 100. For example, the drain electrode D1 of the sub transistor 310 may be electrically connected to the drain electrode D of the main transistor 100 through the node N1, and the source electrode S1 of the sub transistor 310 may be electrically connected to the resistive element 320 (e.g., a resistor) through a node N4. The drain electrode D1 of the sub transistor 310 may be electrically connected to a power source supplying the power voltage $V_D$ through the node N1. Further, the source electrode S1 of the sub transistor 310 may be electrically connected to a sensing unit 500 through the node N4.

Furthermore, the gate electrode G1 of the sub transistor 310 may be electrically connected to the gate electrode G of the main transistor 100 through a node N3. Accordingly, to the gate electrode G1 of the sub transistor 310 and the gate electrode G of the main transistor 100, the same signal may be applied. For example, when a turn-on signal is applied to the gate electrode G of the main transistor 100, the same turn-on signal may be applied to the gate electrode G1 of the sub transistor 310. Also, when a turn-off signal is applied to the gate electrode G of the main transistor 100, the same turn-off signal may be applied to the gate electrode G1 of the sub transistor 310. Therefore, when current flows from the drain electrode D of the main transistor 100 to the source electrode S as a turn-on signal is applied to the gate electrode G of the main transistor 100, current may flow from the drain electrode D1 of the sub transistor 310 to the source electrode S1 as well. In other words, when the main transistor 100 is turned on, the sub transistor 310 may be turned on as well.

The drain electrode D1 of the sub transistor 310 in FIG. 1 may correspond to the sub drain electrode 175s of the sub transistor 310 in FIG. 2, the source electrode S1 of the sub transistor 310 in FIG. 1 may correspond to the sensing electrode SE of the sub transistor 310 in FIG. 2, and the gate electrode G1 of the sub transistor 310 in FIG. 1 may correspond to the sub gate electrode 155s of the sub transistor 310 in FIG. 2. As shown in FIG. 2, the sub transistor 310 may be divided off by a separation structure 160 and be configured as a portion of the main transistor 100 which is positioned in the peripheral circuit area PA, but is not limited thereto.

The resistive element 320 may be electrically connected between terminals of the main transistor 100 and the sub transistor 310. As reflected in FIG. 1, one terminal of the resistive element 320 may be electrically connected to the source electrode S of the main transistor 100 via an electrical connection with node N2. One terminal of the resistive element 320 may be electrically connected to the main source electrode (reference symbol "173m" in FIG. 2) of the main transistor 100 through the second node N2. The electrical connection with node N2 may also electrically connect the terminal of resistive element 320 with a power source having the power voltage Vs, and thus the power voltage Vs may be supplied to that terminal of the resistive element 320.

Another terminal of the resistive element 320 may be electrically connected to the source electrode S1 of the sub transistor 310 and to the sensing unit 500 via an electrical connection with node N4. The resistive element 320 may correspond to the resistance between the sensing electrode SE and the main source electrode 173m in FIG. 2. Furthermore, the node N4 may be a point corresponding to the sensing electrode SE. This will be described below with reference to FIGS. 2 to 8.

The sensing unit 500 (e.g., a circuit forming a sensor) may be electrically connected to the sub transistor 310 and the resistive element 320. For example, the sensing unit 500 may be electrically connected to the source electrode S1 of the sub transistor 310 and one terminal of the resistive element 320 through the node N4. The sensing unit 500 may detect at least one of the voltage of the source electrode S1 of the sub transistor 310 and the voltage of one terminal of the resistive element 320 (for example, a sensing voltage Vcs of the node N4).

The sensing unit 500 may sense an overcurrent condition in at least one of the main transistor 100 and the sub transistor 310, on the basis of the voltage sensed by the sensing unit 500.

Specifically, when the main transistor 100 is turned on, current may flow from the drain electrode D of the main transistor 100 to the source electrode S. Meanwhile, as described above, since the gate electrode G of the main transistor 100 and the gate electrode G1 of the sub transistor 310 are electrically connected, when the main transistor 100 is turned on, the sub transistor 310 may be turned on as well. Accordingly, when the sub transistor 310 is turned on, current may flow from the drain electrode D1 of the sub transistor 310 to the source electrode S1 as well, and may flow in the resistive element 320 through the node N4. As a result, across the resistive element 320, a voltage drop may occur in proportion to the magnitude of the current flowing through the sub transistor 310. The sensing voltage Vcs of the node N4 may proportional to the magnitude of the current flowing through the sub transistor 310. Further, the magnitude of the current flowing in the main transistor 100 and the magnitude of the current flowing in the sub transistor 310 may be determined by a current divider. Accordingly, the sensing voltage $V_{CS}$ of the node N4 may represent the magnitude of the current flowing in the main transistor 100. As an example, in the event of an overcurrent condition in at least one of the main transistor 100 and the sub transistor 310, the sensing voltage $V_{CS}$ of the node N4 may be greater than sensing voltages $V_{CS}$ in a pre-stored range.

Therefore, the sensing unit 500 may calculate the magnitude of at least one of the current flowing in the main transistor 100 and the current flowing in the sub transistor 310 on the basis of the magnitude of the sensing voltage $V_{CS}$ that is sensed by the sensing unit. In other words, when a sensing voltage Vcs in a range greater than voltages in the pre-stored range is detected, the sensing unit 500 may detect whether an overcurrent condition exists in at least one of the main transistor 100 and the sub transistor 310.

In some embodiments, the sensing unit 500 may control the semiconductor device on the basis of a detected signal (for example, at least one of current and voltage) such that the semiconductor device performs an additional operation. For example, when an overcurrent condition exists in at least one of the main transistor 100 and the sub transistor 310, the sensing unit 500 may further perform a function of stopping a driving operation of the semiconductor device. Alternatively, the sensing unit 500 may further perform a function of compensating and protecting the current flowing in at least one of the main transistor 100 and the sub transistor 310 to operate within a preset range. Here, a compensating circuit may refer to a circuit for compensating for the operation loss of at least one of the main transistor 100 and the sub transistor 310 such that the semiconductor device operates within the preset range. Protection elements may be circuits for preventing the semiconductor device including the main transistor 100 from being broken down, such as an overcurrent protection element, an overvoltage protection element, an overtemperature protection element, a short-circuit protection element, an electrostatic discharge protection element, a low drop-output (LDO) regulator, etc.

Hereinafter, the main transistor 100 of the semiconductor device according various embodiments will be described with reference to FIGS. 2 to 4.

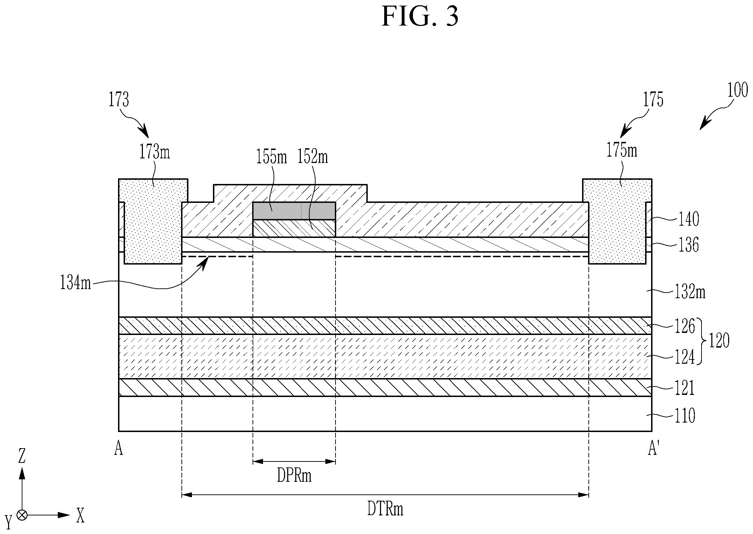

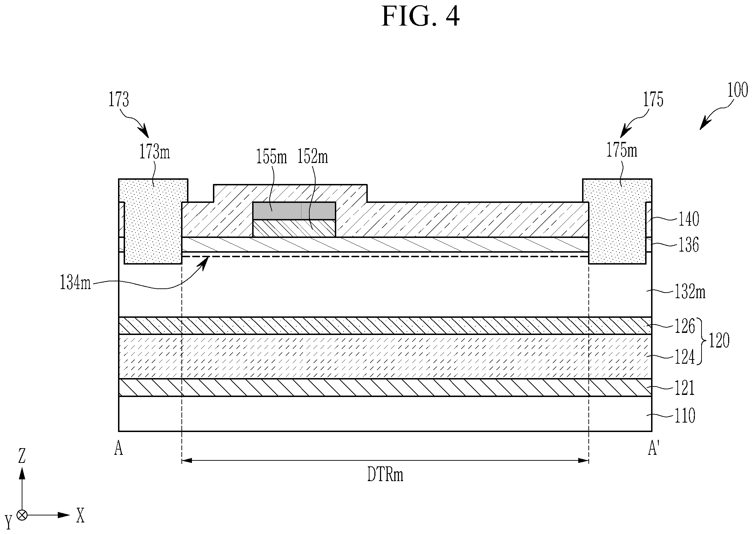

FIG. 2 is a plan view illustrating the semiconductor device according to some embodiments. FIGS. 3 and 4 are cross-sectional views taken along line A-A' of FIG. 2. FIG. 3 illustrates a scenario in which the semiconductor device is off according to some embodiments, and FIG. 4 illustrates a scenario in which the semiconductor device is on according to some embodiments.

Referring to FIG. 2, the peripheral circuit area PA of the semiconductor device may be positioned apart from the main element area MA. For example, the peripheral circuit area PA may be positioned apart from the main element area MA in a second direction (a Y direction), but is not limited thereto. For example, the peripheral circuit area PA may be positioned apart from the main element area MA in a first direction (an X direction), or may surround the side surface of the main element area MA. Of course, various other changes are possible. A separation structure 160 may be positioned between the peripheral circuit area PA and the main element area MA, however, the present disclosure is not limited thereto. The semiconductor device may include a channel layer 132, a gate electrode layer 155, and a drain electrode layer 175. Some respective portions of the channel layer 132, gate electrode layer 155, and drain electrode layer 175 may be positioned in the main element area MA. Other respective portions of the channel layer 132, gate electrode layer 155, and drain electrode layer 175 may be positioned in the peripheral circuit area PA.

Referring to FIGS. 2 and 3, the main transistor 100 of the semiconductor device may include a main channel layer 132m, a barrier layer 136 that is positioned on the main channel layer 132m, a main gate electrode 155m that is positioned on the barrier layer 136, a gate semiconductor layer 152m that is positioned between the barrier layer 136 and the main gate electrode 155m, a protective layer 140 that is positioned on the barrier layer 136, and a main source electrode 173m and a main drain electrode 175m that are spaced apart from each other on the main channel layer 132m. The main channel layer 132m may be a portion of channel layer 132 that is positioned in the main element area MA. The main gate electrode 155m may be a portion of gate electrode layer 155 that is positioned in the main element area MA. The main drain electrode 175m may be a portion of drain electrode layer 175 that is positioned in the main element area MA. The main source electrode 173m may be a portion of a source electrode layer 173 that is positioned in the main element area MA and the sensing electrode SE may be a portion of the source electrode layer 173 that is positioned in the peripheral circuit area PA.

The main channel layer 132m may be a layer that forms a channel between the main source electrode 173m and the main drain electrode 175m, and inside the main channel layer 132m, a 2-dimensional electron gas (2DEG) region 134m may be positioned. More particularly, the 2DEG region 134m may be located in an area of the main channel layer 132m that is in relative proximity to an interface between the main channel layer 132m and the barrier layer 136. The 2DEG region 134m may reside within a main drift region DTRm of the main channel layer 132m In the 2DEG region 134m, electrons may be relatively tightly confined in one dimension (e.g., the vertical or Z dimension in FIG. 3), but may be relatively free to move in two other dimensions (e.g., the horizontal or X and Y dimensions in FIG. 3). In other words, in the 2DEG region 134m, movement of electrons may be substantially confined to a two-dimensional sheet (e.g., plane) in three-dimensional space. The behavior of the electrons in the 2DEG region 134m may thus be understood and/or predicted according to a 2-dimensional electron gas model and may be referenced as a 2-dimentional electron gas. Such 2-dimensional electron gases mainly appear in semiconductor heterojunction structures, and in the semiconductor device according to the embodiment, the 2-dimensional electron gas may occur at the interface between the main channel layer 132m and the barrier layer 136. For example, the 2-dimensional electron gas 134 may occur at a portion inside the main channel layer 132m adjacent to the barrier layer 136.

The main channel layer 132m may contain at least one material selected from III-V materials such as nitrides containing Al, Ga, In, B, or a combination thereof. The main channel layer 132m may consist of a single layer (e.g., a homogenous layer formed with the same deposition or growth process) or multiple component layers. The main channel layer 132m may be formed of $Al_xIn_yGa_{1-x-y}N$ (wherein $0{\le}x{\le}1$, $0{\le}y{\le}1$, and $x+y{\le}1$). For example, the main channel layer 132m may contain AlN, GaN, InN, InGaN, AlGaN, AlInN, AlInGaN, or a combination thereof. The main channel layer 132m may be a layer doped with impurities, or may be a layer that is not doped with impurities. The thickness of the main channel layer 132m may be about hundreds of nm or less.

The main channel layer 132m may be positioned on a substrate 110, and between the substrate 110 and the main channel layer 132m, a seed layer 121 and a buffer layer 120 may be positioned. The substrate 110, the seed layer 121, and the buffer layer 120 may be layers used in some embodiments to form the main channel layer 132m. In some embodiments, one or more of the substrate 110, the seed layer 121, and the buffer layer 120 may be omitted. For example, when a substrate made of GaN is used as the main channel layer 132m, at least one of the substrate 110, the seed layer 121, and the buffer layer 120 may be omitted. In consideration of the relatively high prices of substrates made of GaN, a substrate 110 made of Si may be used to grow a main channel layer 132m containing GaN. However, since the lattice structure of Si and the lattice structure of GaN are different, it may not be easy to grow the main channel layer 132m on the substrate 110. Therefore, a seed layer 121 and a buffer layer 120 may be first grown on the substrate 110, and then the main channel layer 132m may be grown on the buffer layer 120. Also, at least one of the substrate 110, the seed layer 121, and the buffer layer 120 may be removed from the final structure of the semiconductor device after being used in the manufacturing process.

The substrate 110 may a layer of semiconductor material. For example, the substrate 110 may be crystalline sapphire, Si, SiC, AlN, GaN, or a combination thereof. The substrate 110 may be a silicon-on-insulator (SOI) substrate. However, the material of the substrate 110 is not limited thereto. In some examples, the substrate 110 may contain an insulating material. For example, several layers including the main channel layer 132m may be formed on a semiconductor substrate first, and then the semiconductor substrate may be removed and replaced with an insulating substrate.

The seed layer 121 may be positioned directly on the substrate 110. However, the present disclosure is not limited thereto, and between the substrate 110 and the seed layer 121, other predetermined layers may be further positioned. The seed layer 121 is a layer to serve as a seed for growing the buffer layer 120, and may be formed of a crystal lattice structure to be a seed for the buffer layer 120. The buffer layer 120 may be positioned directly on the seed layer 121. However, the present disclosure is not limited thereto, and between the seed layer 121 and the buffer layer 120, other predetermined layers may be further positioned. The seed layer 121 may contain at least one material selected from III-V materials such as nitrides containing Al, Ga, In, B, or a combination thereof. The seed layer 121 may be formed of $Al_xIn_yGa_{1-x-y}N$ (wherein $0{\le}x{\le}1$, $0{\le}y{\le}1$, and $x+y{\le}1$). For example, the seed layer 121 may contain AlN, GaN, InN, InGaN, AlGaN, AlInN, AlInGaN, or a combination thereof.

The buffer layer 120 may be positioned on the seed layer 121. The buffer layer 120 may be positioned between the seed layer 121 and the main channel layer 132m. The buffer layer 120 may be a layer for mitigating differences in lattice constant and thermal expansion coefficient between the seed layer 121 and the main channel layer 132m or preventing parasitic current (leakage current) from flowing through the main channel layer 132m. For example, the buffer layer 120 may be formed of one or more layers of a crystalline material having a lattice constant between those of the seed layer 121 and the main channel layer 132m (which may be a constant lattice constant or may be varied to gradually change). The buffer layer 120 may contain at least one material selected from III-V materials such as nitrides containing Al, Ga, In, B, or a combination thereof. The buffer layer 120 may be formed of $Al_xIn_yGa_{1-x-y}N$ (wherein $0{\le}x{\le}1$, $0{\le}y{\le}1$, and $x+y{\le}1$). For example, the buffer layer 120 may contain AlN, GaN, InN, InGaN, AlGaN, AlInN, AlInGaN, or a combination thereof.

The buffer layer 120 of the semiconductor device may include a superlattice layer 124 that is positioned on the seed layer 121, and a high-resistivity layer 126 that is positioned on the superlattice layer 124. The superlattice layer 124 and the high-resistivity layer 126 may be sequentially positioned on the substrate 110.

The superlattice layer 124 may be positioned on the seed layer 121. The superlattice layer 124 may be positioned directly on the seed layer 121. However, the present disclosure is not limited thereto, and between the seed layer 121 and the superlattice layer 124, other predetermined layers may be further positioned. The superlattice layer 124 is a layer for migrating differences in lattice constant and thermal expansion coefficient between the substrate 110 and the main channel layer 132m, thereby relieving tensile stress and compressive stress that is generated between the substrate 110 and the main channel layer 132m and relieving stress between all layers formed by growth in the final structure of the semiconductor device. The superlattice layer 124 may contain at least one material selected from III-V materials such as nitrides containing Al, Ga, In, B, or a combination thereof. The superlattice layer 124 may be formed of $Al_xIn_yGa_{1-x-y}N$ (wherein $0≤x≤1$, $0≤y≤1$, and $x+y≤1$). For example, the superlattice layer 124 may contain AlN, GaN, InN, InGaN, AlGaN, AlInN, AlInGaN, or a combination thereof.

The superlattice layer 124 may consist of multiple layers containing different materials and alternately stacked. For example, the superlattice layer 124 may have a structure in which layers including AlGaN and layers including AlN are alternately stacked. For example, AlGaN, AlN, AlGaN, AlN, AlGaN, and AlN may be sequentially stacked to form the superlattice layer. The numbers of AlGaN layers and AlN layers which constitute the superlattice layer 124 may be variously changed, and the materials which constitute the superlattice layer 124 may be variously changed. As another example, the superlattice layer 124 may have a structure in which layers including AlGaN and layers including GaN are alternately stacked. For example, AlGaN, GaN, AlGaN, GaN, AlGaN, and GaN may be sequentially stacked to form the superlattice layer. In some embodiments, when the superlattice layer 124 contains GaN, InN, AlGaN, AlInN, InGaN, AlN, AlInGaN, a combination thereof, etc., the superlattice layer 124 may have an n-type semiconductor characteristic in which the concentration of carrier electrons is greater than the concentration of carrier holes, however, the present disclosure is not limited thereto.

The high-resistivity layer 126 may be positioned on the superlattice layer 124. The high-resistivity layer 126 may be positioned directly on the superlattice layer 124. However, the present disclosure is not limited thereto, and between the superlattice layer 124 and the high-resistivity layer 126, other predetermined layers may be further positioned. The high-resistivity layer 126 may be positioned between the superlattice layer 124 and the main channel layer 132m. The high-resistivity layer 126 may be a layer for preventing leakage current from flowing through the main channel layer 132m, thereby protecting the semiconductor device from deterioration. The high-resistivity layer 126 may include a material having low conductivity such that the substrate 110 and the main channel layer 132m can be electrically insulated from each other. The high-resistivity layer may contain at least one material selected from III-V materials such as nitrides containing Al, Ga, In, B, or a combination thereof. The high-resistivity layer 126 may be formed of $Al_xIn_yGa_{1-x-y}N$ (wherein $0≤x≤1$, $0≤y≤1$, and $x+y≤1$). For example, the high-resistivity layer 126 may contain AlN, GaN, InN, InGaN, AlGaN, AlInN, AlInGaN, or a combination thereof. The high-resistivity layer 126 may include a single layer or multiple layers. In some embodiments, when the high-resistivity layer 126 contains GaN, InN, AlGaN, AlInN, InGaN, AlN, AlInGaN, a combination thereof, etc., the high-resistivity layer 126 may have an n-type semiconductor characteristic in which the concentration of electrons is greater than the concentration of holes, however, the present disclosure is not limited thereto.

The barrier layer 136 may be positioned on the main channel layer 132m. The barrier layer 136 may be positioned directly on the main channel layer 132m. However, the present disclosure is not limited thereto, and between the main channel layer 132m and the barrier layer 136, other predetermined layers may be further positioned. A region of the main channel layer 132m overlapping the barrier layer 136 between the main source electrode 173m and the main drain electrode 175m may become a main drift region DTRm. The main drift region DTRm may be positioned between the main source electrode 173m and the main drain electrode 175m. The main drift region DTRm may refer to a region in which carriers move when a potential difference occurs between the main source electrode 173m and the main drain electrode 175m.

The semiconductor device may be turned on and off according to at least one of whether voltage is applied to the main gate electrode 155m and the magnitude of voltage which is applied to the main gate electrode 155m, whereby movement of charge carriers (electrons or holes) in the main drift region DTRm may be enabled or blocked.

The barrier layer 136 may be a crystalline semiconductor material and may contain at least one material selected from III-V materials such as nitrides containing Al, Ga, In, B, or a combination thereof. The barrier layer 136 may be formed of $Al_xIn_yGa_{1-x-y}N$ (wherein $0≤x≤1$, $0≤y≤1$, and $x+y≤1$). The barrier layer 136 may contain GaN, InN, AlGaN, AlInN, InGaN, AlN, AlInGaN, a combination thereof, etc. The energy band gap of the barrier layer 136 may be adjusted by the proportion of at least one of Al and In. The barrier layer 136 may be doped with a predetermined impurity. The impurity with which the barrier layer 136 is doped may be a p-type dopant capable of providing holes. For example, the impurity with which the barrier layer 136 is doped may be magnesium (Mg). By increasing or decreasing the concentration of the impurity with which the barrier layer 136 is doped, the threshold voltage, impedance, and the like of the semiconductor device may be adjusted.

The barrier layer 136 may contain a semiconductor material having different characteristics from those of the main channel layer 132m. At least one of the polarization characteristics, energy band gap, and lattice constant of the barrier layer 136 may be different from that of the main channel layer 132m. For instance, the barrier layer 136 may contain a material having an energy band gap different from that of the main channel layer 132m. In an example, the barrier layer 136 may have an energy band gap higher than that of the main channel layer 132m, and may have electrical polarizability higher than that of the main channel layer 132m. By this barrier layer 136, the 2-dimensional electron gas may be induced in the main channel layer 132m (in the 2DEG region 134m) having relatively low electrical polarizability. In this sense, the barrier layer 136 may be referred to as a channel supply layer or a 2-dimensional electron gas supply layer. The 2DEG region 134m may be formed in a portion of the main channel layer 132m positioned below the interface between the main channel layer 132m and the barrier layer 136. The 2DEG region 134m may have very high electron mobility.

The barrier layer 136 may consist of a single homogenous layer or multiple component layers. When the barrier layer 136 includes multiple layers, the materials of the individual layers constituting the multiple layers may have different energy band gaps. In such a case, the multiple layers constituting the barrier layer 136 may be disposed such that a layer closer to the main channel layer 132m has a higher energy band gap.

The main gate electrode 155m may be positioned on the barrier layer 136. The main gate electrode 155m may overlap a partial region of the barrier layer 136 in a vertical direction (for example, the thickness direction of the main channel layer 132m). The main gate electrode 155m may overlap a portion of the main drift region DTRm of the main channel layer 132m in the vertical direction (for example, the thickness direction of the main channel layer 132m). The main gate electrode 155m may be positioned between the main source electrode 173m and the main drain electrode 175m. The main gate electrode 155m may be spaced apart from the main source electrode 173m and the main drain electrode 175m. For example, the main gate electrode 155m may be positioned closer to the main source electrode 173m than to the main drain electrode 175m. In other words, the separation distance between the main gate electrode 155m and the main source electrode 173m may be smaller than the separation distance between the main gate electrode 155m and the main drain electrode 175m, however, the present disclosure is not limited thereto.

The main gate electrode 155m may contain a conductive material. For example, the main gate electrode 155m may contain a metal, a metal alloy, a conductive metal nitride, a metal silicide, a doped semiconductor material, a conductive metal oxide, a conductive metal oxynitride, or the like. For example, the main gate electrode 155m may contain titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbo-nitride (TiAlC-N), titanium aluminum carbide (TiAlC), titanium carbide (TiC), tantalum carbo-nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The main gate electrode 155m may consist of a single homogenous layer or multiple component layers.

The gate semiconductor layer 152m may be positioned between the barrier layer 136 and the main gate electrode 155m. In other words, the gate semiconductor layer 152m may be positioned on the barrier layer 136, and the main gate electrode 155m may be positioned on the gate semiconductor layer 152m, so as to cover at least a portion of the gate semiconductor layer 152m. The main gate electrode 155m may be brought into Schottky contact or ohmic contact with the gate semiconductor layer 152m. The gate semiconductor layer 152m may overlap the main gate electrode 155m in the vertical direction (for example, the thickness direction of the main channel layer 132m). In some embodiments, the gate semiconductor layer 152m may completely overlap the main gate electrode 155m in the vertical direction (for example, the thickness direction of the main channel layer 132m), and the upper surface of the gate semiconductor layer 152m may be entirely covered by the main gate electrode 155m. In other words, the gate semiconductor layer 152m may have substantially the same plane shape as that of the main gate electrode 155m. However, the present disclosure is not limited thereto., In some examples, the main gate electrode 155m may be positioned so as to cover only a portion of the gate semiconductor layer 152m.

The gate semiconductor layer 152m may be positioned between the main source electrode 173m and the main drain electrode 175m. The gate semiconductor layer 152m may be spaced apart from the main source electrode 173m and the main drain electrode 175m. The gate semiconductor layer 152m may be positioned closer to the main source electrode 173m than to the main drain electrode 175m. In other words, the separation distance between the gate semiconductor layer 152m and the main source electrode 173m may be smaller than the separation distance between the gate semiconductor layer 152m and the main drain electrode 175m, however, the present disclosure is not limited thereto.

The gate semiconductor layer 152m may overlap the main gate electrode 155m in the vertical direction (for example, the thickness direction of the main channel layer 132m). For example, the gate semiconductor layer 152m may completely overlap the main gate electrode 155m in the vertical direction (for example, the thickness direction of the main channel layer 132m). In other words, the side surface of the gate semiconductor layer 152m may be aligned with the side surface of the main gate electrode 155m. However, the present disclosure is not limited thereto, and the gate semiconductor layer 152m may partially overlap the main gate electrode 155m.

The gate semiconductor layer 152m may contain at least one material selected from III-V materials such as nitrides containing Al, Ga, In, B, or a combination thereof. The gate semiconductor layer 152m may be formed of $Al_xIn_yGa_{1-x-y}N$ (wherein $0 \leq x \leq 1$, $0 \leq y \leq 1$, and $x+y \leq 1$). For example, the gate semiconductor layer 152m may contain AlN, GaN, InN, InGaN, AlGaN, AlInN, AlInGaN, or a combination thereof. The gate semiconductor layer 152m may contain a material having an energy band gap different from that of the barrier layer 136. For example, the gate semiconductor layer 152m may contain GaN, and the barrier layer 136 may contain AlGaN. The gate semiconductor layer 152m may be doped with a predetermined impurity. The impurity with which the gate semiconductor layer 152m is doped may be a p-type dopant capable of providing holes. For example, the gate semiconductor layer 152m may contain GaN doped with a p-type impurity. In other words, the gate semiconductor layer 152m may include a p-GaN layer. However, the gate semiconductor layer 152m is not limited thereto, and may be a p-AlGaN layer. In an example, the impurity with which the gate semiconductor layer 152m is doped may be magnesium (Mg). When the impurity (for example, magnesium) implanted into the gate semiconductor layer 152m is combined with some elements adjacent thereto, the hole concentration in the gate semiconductor layer 152m may decrease, and thus the characteristics of the semiconductor device may deteriorate. The gate semiconductor layer 152m may include a single layer or multiple layers.

By the gate semiconductor layer 152m, a depletion region DPRm may be formed inside the main channel layer 132m. The depletion region DPRm may be positioned inside the main drift region DTRm, and may have a width smaller than that of the main drift region DTRm. As the gate semiconductor layer 152m having an energy band gap different from that of the barrier layer 136 is positioned on the barrier layer 136, the level of the energy band of a portion of the barrier layer 136 overlapping the gate semiconductor layer 152m may be raised. Accordingly, the depletion region DPRm may be formed in the main channel layer 132m overlapping the gate semiconductor layer 152m. The depletion region DPRm may be a region on the channel path of the main channel layer 132m where the 2DEG region 134m is not formed or which has an electron carrier concentration lower than that of the other regions. In other words, the depletion region DPRm may refer to a region in the main drift region DTRm where the in which voltage is not applied to the main gate electrode 155m2DEG region 134m is cut. As the depletion region DPRm is generated, in a normal state, no current may flow between the main source electrode 173m and the main drain electrode 175m, and the channel path may be blocked. Accordingly, the semiconductor device according to the embodiment may have a normally-off characteristic.

Thus, the semiconductor device according to the embodiment may be a normally-off high electron mobility transistor (HEMT). As shown in FIG. 3, in a normal state in which voltage is not applied to the main gate electrode 155m, the depletion region DPRm may exist, and the semiconductor device according to the embodiment may be off. As shown in FIG. 4, when a voltage equal to or higher than a threshold voltage is applied to the main gate electrode 155m, the depletion region DPRm may disappear, and the 2-dimensional electron gas may and the 2DEG region 134m may continue inside the main drift region DTRm, without being cut. Thus, the 2DEG region 134m may be formed over the entire channel path between the main source electrode 173m and the main drain electrode 175m, and the semiconductor device may be turned on. In summary, the semiconductor device may include semiconductor layers having different electrical polarization characteristics, and a semiconductor layer having relatively high polarizability may cause the 2DEG region 134m in another semiconductor layer forming a heterojunction with it. This 2DEG region 134m may be used as a channel between the main source electrode 173m and the main drain electrode 175m, and the continuation or interruption of the flow of electrons in the 2DEG region 134m may be controlled by a bias voltage that is applied to the main gate electrode 155m. In the gate-off state (e.g., the main gate electrode 155m does not have a voltage equal to or higher than the threshold voltage applied), the flow of electrons in the 2DEG region 134m may be blocked, whereby no current flows between the main source electrode 173m and the main drain electrode 175m. In the gate-on state (e.g., the main gate electrode 155m has a voltage equal to or higher than the threshold voltage applied), as the flow of electrons in the 2DEG region 134m continues, current may flow between the main source electrode 173m and the main drain electrode 175m.

Although it has been described above that the semiconductor device may be a normally-off high electron mobility transistor, the present disclosure is not limited thereto. In some embodiments, the semiconductor device may be a normally-on high electron mobility transistor. When the semiconductor device is a normally-on high electron mobility transistor, the gate semiconductor layer 152m may be omitted, whereby the main gate electrode 155m may be positioned directly on the barrier layer 136. In other words, the main gate electrode 155m may be in contact with the barrier layer 136. In this structure, in a state where no voltage is applied to the main gate electrode 155m, the 2DEG region 134m may be used as a channel, and a flow of current may occur between the main source electrode 173m and the main drain electrode 175m. Further, when a negative voltage is applied to the main gate electrode 155m, the depletion region DPRm where the flow of electrons in the 2DEG region 134m is cut may occur under the main gate electrode 155m.

The seed layer 121, the superlattice layer 124, the high-resistivity layer 126, the main channel layer 132m, the barrier layer 136, and the gate semiconductor layer 152m described above may be sequentially stacked on the substrate 110. In some embodiments, at least one of the seed layer 121, the superlattice layer 124, the high-resistivity layer 126, the main channel layer 132m, the barrier layer 136, and the gate semiconductor layer 152m may be omitted. The seed layer 121, the superlattice layer 124, the high-resistivity layer 126, the main channel layer 132m, the barrier layer 136, and the gate semiconductor layer 152m may consist of semiconductor materials based on the same materials, and the material composition ratios of the individual layers may be different from one another, and may be selected in view of the roles of the individual layers, the level of performance desired for the semiconductor device, and the like.

The protective layer 140 may be positioned on the barrier layer 136 and the main gate electrode 155m. The protective layer 140 may cover the upper surface and side surface of the main gate electrode 155m and the side surface of the gate semiconductor layer 152m. The lower surface of the protective layer 140 may be in contact with the barrier layer 136 and the main gate electrode 155m. Accordingly, the barrier layer 136, the gate semiconductor layer 152m, and the main gate electrode 155m may be protected by the protective layer 140. However, the present disclosure is not limited thereto, and the main gate electrode 155m may pass through the protective layer 140 and be connected to the gate semiconductor layer 152m, and the protective layer 140 may not cover the upper surface of the main gate electrode 155m. Also, the lower surface of the protective layer 140 may be in contact with the gate semiconductor layer 152m. The protective layer 140 may contain an insulating material. For example, the protective layer 140 may contain an oxide such as $SiO_2$, $Al_2O_3$, etc. As another example, the protective layer 140 may contain a nitride such as SiN, or an oxynitride such as SiON.

It is shown in FIGS. 3 and 4 that the protective layer 140 includes a single layer. However, the protective layer 140 is not limited thereto, and may include multiple layers containing different materials.

The main source electrode 173m and the main drain electrode 175m may be positioned on the main channel layer 132m. The main source electrode 173m and the main drain electrode 175m may be in contact with the main channel layer 132m, and may be electrically connected to the main channel layer 132m.

The main source electrode 173m and the main drain electrode 175m may extend in the second direction (the Y direction). The main source electrode 173m and the main drain electrode 175m may be spaced apart from each other, and the main gate electrode 155m and the gate semiconductor layer 152m may be positioned between the main source electrode 173m and the main drain electrode 175m. The main gate electrode 155m and the gate semiconductor layer 152m may be spaced apart from the main source electrode 173m and the main drain electrode 175m. For example, the main source electrode 173m may be electrically connected to the main channel layer 132m on one side of the main gate electrode 155m, and the main drain electrode 175m may be electrically connected to the main channel layer 132m on the other side of the main gate electrode 155m. The main source electrode 173m and the main drain electrode 175m may be positioned outside of the main drift region DTRm of the main channel layer 132m.

In some embodiments, the main source electrode 173m and the main drain electrode 175m may be positioned inside spaces formed by recessing at least some portions of the main channel layer 132m. In some embodiments, as depicted in FIGS. 3 and 4, surfaces of the main source electrode 173m and the main drain electrode 175m that contact the main channel layer 132m may include both bottom surfaces and side surfaces of the main source electrode 173m and the main drain electrode 175m. In such an embodiment, an interface between an inner side surface of main source electrode 173m (in FIGS. 3 and 4, a surface on the side of main source electrode 173m that faces towards main drain electrode 175m) and the main channel layer 132m may define one edge of the main drift region DTRm. Similarly, an interface between an inner side surface of main drain electrode 175m (in FIGS. 3 and 4, a surface on the side of main drain electrode 175m that faces towards main source electrode 173m) and the main channel layer 132m may define the other edge of the main drift region DTRm.

In other embodiments, the main channel layer 132m may not be recessed, and the main source electrode 173m and the main drain electrode 175m may be positioned on the upper surface of the main channel layer 132m. In such an embodiment, the bottom surfaces of the main source electrode 173m and the main drain electrode 175m may contact the upper surface of the main channel layer 132m, but the main channel layer 132m may not be in contact with any side surfaces of the main source electrode 173m and the main drain electrode 175m.

The portions of the main channel layer 132m that are in contact with the main source electrode 173m and the main drain electrode 175m may be doped at a high concentration. Carriers passing through the 2DEG region 134m may be transferred to the main source electrode 173m and the main drain electrode 175m through the portions of the main channel layer 132m doped at the high concentration, i.e., the upper portions of the 2DEG region 134m. The main source electrode 173m and the main drain electrode 175m may or may not contact the 2DEG region 134m in a horizontal direction. Here, the horizontal direction may refer to a direction parallel with the upper surface of the main channel layer 132m or the barrier layer 136.

In some embodiments, two trenches may be formed, on opposite respective sides of the main gate electrode 155m, that pass through the protective layer 140, the barrier layer 136 and portions of the upper surface of the main channel layer 132m, and the main source electrode 173m and the main drain electrode 175m may be positioned inside the trenches. The main source electrode 173m and the main drain electrode 175m may be formed so as to fill the trenches. Inside the trenches, the main source electrode 173m and the main drain electrode 175m may be in contact with the main channel layer 132m and the barrier layer 136. The main channel layer 132m may constitute the bottom surfaces and side walls of the trenches, and the barrier layer 136 may constitute the side walls of the trenches. Therefore, the main source electrode 173m and the main drain electrode 175m may be in contact with the upper surface and side surface of the main channel layer 132m. Further, the main source electrode 173m and the main drain electrode 175m may be in contact with the side surface of the barrier layer 136. In other words, the main source electrode 173m and the main drain electrode 175m may cover the side surfaces of the main channel layer 132m and the barrier layer 136.

In some embodiments, the main source electrode 173m and the main drain electrode 175m may cover at least a portion of one or more side surfaces of the protective layer 140. In some examples, the main source electrode 173m and the main drain electrode 175m may entirely cover one or more side surfaces of the protective layer 140. The upper surfaces of the main source electrode 173m and the main drain electrode 175m may protrude from the upper surface of the protective layer 140. In some embodiments, at least one of the main source electrode 173m and the main drain electrode 175m may cover at least a portion of the upper surface of the protective layer 140. However, the main source electrode 173m and the main drain electrode 175m are not limited thereto. In some examples, one or more portions of the protective layer 140 may be positioned on one or more portions of the upper surface of the main source electrode 173m, the upper surface of the main drain electrode 175m, or both.

The main source electrode 173m and the main drain electrode 175m may contain a conductive material. For example, the main source electrode 173m and the main drain electrode 175m may contain a metal, a metal alloy, a conductive metal nitride, a metal silicide, a doped semiconductor material, a conductive metal oxide, a conductive metal oxynitride, or the like. For example, the main source electrode 173m and the main drain electrode 175m may contain titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbo-nitride (TiAlC-N), titanium aluminum carbide (TiAlC), titanium carbide (TiC), tantalum carbo-nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The main source electrode 173m and the main drain electrode 175m may include a single layer or multiple layers. The main source electrode 173m and the main drain electrode 175m may be in ohmic contact with the main channel layer 132m. The regions in the main channel layer 132m which are in contact with the main source electrode 173m and the main drain electrode 175m may be doped at a relatively higher concentration as compared to the other region.

In FIGS. 3 and 4, it is shown that the semiconductor device may include one main source electrode 173m and one main drain electrode 175m. However, the numbers of main source electrodes 173m and main drain electrodes 175m are not limited thereto. For example, in some embodiments, the main source electrode 173m may include a plurality of source electrodes sequentially stacked in the vertical direction (for example, the thickness direction of the main channel layer 132m) on the main channel layer 132m, and the main drain electrode 175m may include a plurality of drain electrodes sequentially stacked in the vertical direction (for example, the thickness direction of the main channel layer 132m) on the main channel layer 132m. Alternatively, each of the main source electrode 173m and the main drain electrode 175m may include three or more layers.

Although not shown in the drawings, in some embodiments, the semiconductor device may further include a field dispersion layer that covers at least a portion of the protective layer 140.

The field dispersion layer may be positioned between the main source electrode 173m and the main drain electrode 175m. The field dispersion layer may cover the main gate electrode 155m. The field dispersion layer may overlap the main gate electrode 155m in the vertical direction (for example, the thickness direction of the main channel layer 132m). The field dispersion layer may be electrically connected to the main source electrode 173m. For example, the field dispersion layer may be connected to the main source electrode 173m. The field dispersion layer may be formed of the same material as that of the main source electrode 173m, and may be positioned together with the main source electrode 173m in the same layer. The field dispersion layer may be formed together with the main source electrode 173m in the same process (e.g., they may be pattern elements of the same conductive layer). The boundary between the field dispersion layer and the main source electrode 173m may not be clear, and the field dispersion layer may be formed integrally with the main source electrode 173m. However, the field dispersion layer is not limited thereto, and may be an individual constituent element separated from the main source electrode 173m. Also, the field dispersion layer and the main source electrode 173m may be elements of different layers, respectively, and may be formed in different processes, respectively.

The field dispersion layer may serve to disperse an electric field concentrated around the main gate electrode 155m. Specifically, in the gate-off state, the 2DEG region 134m may be positioned with a very high concentration in the portion of the main channel layer 132m positioned between the main gate electrode 155m and the main source electrode 173m and the portion of the main channel layer 132m positioned between the main gate electrode 155m and the main drain electrode 175m. In this case, the electric field may be concentrated on the main gate electrode 155m or the gate semiconductor layer 152m. Meanwhile, since the main gate electrode 155m and the gate semiconductor layer 152m are vulnerable to electric fields, when an electric field is concentrated on them, leakage current may increase, and the breakdown voltage of the main transistor 100 may decrease. In this case, the electric field concentrated around the main gate electrode 155m or the gate semiconductor layer 152m may be dispersed by the field dispersion layer, whereby leakage current may be reduced and the breakdown voltage (VZth) may be increased.

The main transistor 100 of the semiconductor device may include one main source electrode 173m, one main drain electrode 175m, and one main gate electrode 155m, but is not limited thereto. For example, a main transistor 100 of a semiconductor device according to some embodiments may include a plurality of main source electrodes 173m, a plurality of main drain electrodes 175m, and a plurality of main gate electrodes 155m. For example, the main transistor 100 may include a plurality of electrode sets, and each of the plurality of electrode sets may include one main source electrode 173m, one main drain electrode 175m, and one main gate electrode 155m. The main source electrodes 173m of the plurality of electrode sets may be electrically connected to one another, and the main gate electrodes 155m of the plurality of electrode sets may be electrically connected to one another, and the main drain electrodes 175m of the plurality of electrode sets may be electrically connected to one another. Accordingly, the plurality of electrode sets may function as one main transistor 100, however, the present disclosure is not limited thereto.

In an embodiment in which the main transistor 100 includes a plurality of electrode sets, the sub transistor 310 and the resistive element 320 may be electrically connected to at least one of the plurality of electrode sets. For example, the sub transistor 310 and the resistive element 320 may be electrically connected to the main source electrode 173m of at least one of the plurality of electrode sets. In such an example, the sub transistor 310 and the resistive element 320 may be divided off by the separation structure 160 and be configured as a portion of one of the plurality of electrode sets that is positioned in the peripheral circuit area PA.

In some embodiments, the main transistor 100 may include a plurality of electrode sets that are arranged in one direction (for example, the first direction (the X direction)). In this case, electrode sets neighboring in one direction may have shapes symmetrical to each other with respect to another direction intersecting with the one direction (for example, with respect to the second direction (the Y direction)). For example, the plurality of electrode sets may include first electrode sets and second electrode sets having shapes symmetrical to each other, and the first electrode sets and the second electrode sets may be alternately arranged in the first direction (the X direction). In each first electrode set, the main source electrode 173m, the main gate electrode 155m, and the main drain electrode 175m may be sequentially positioned in a direction away from one side of the corresponding first electrode set in the first direction (the X direction), and in each second electrode set, the main drain electrode 175m, the main gate electrode 155m, and the main source electrode 173m may be sequentially positioned in a direction away from one side of the corresponding second electrode sets in the first direction (the X direction), however, the present disclosure is not limited thereto.

Hereinafter, the peripheral circuit element 300 of the semiconductor device according to various embodiments will be described with reference to FIG. 2 and FIGS. 5 to 9.

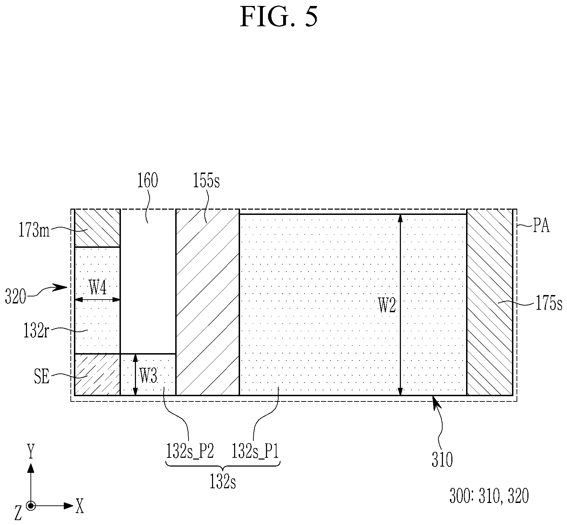

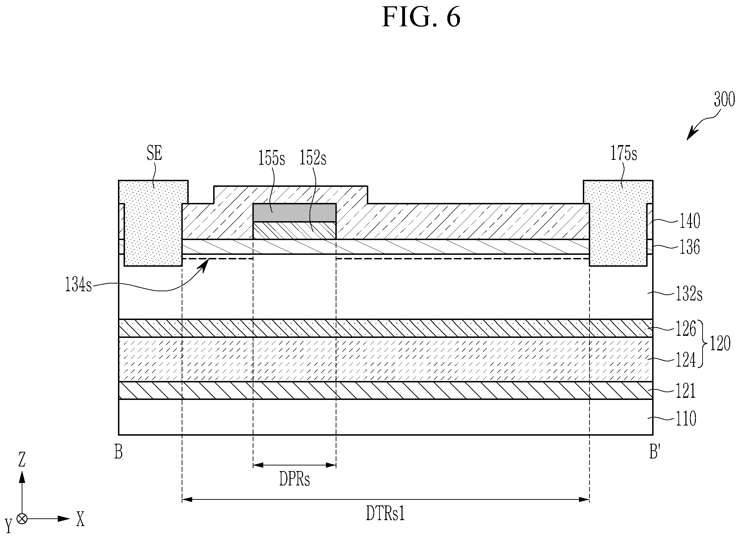

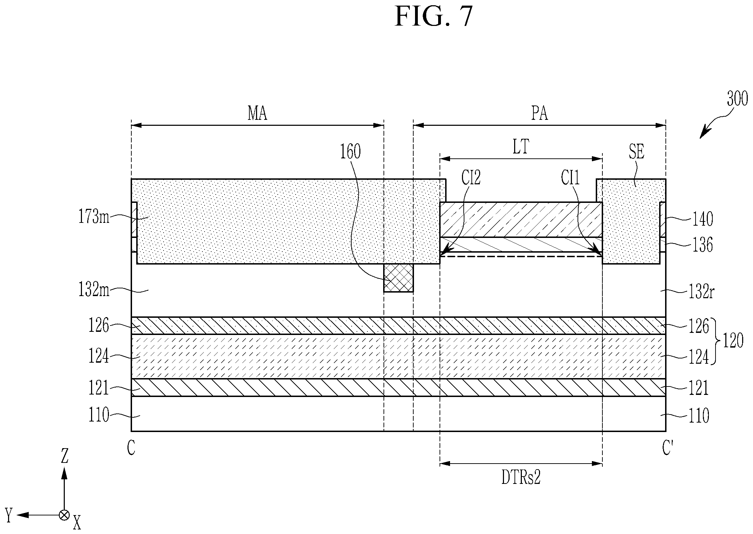

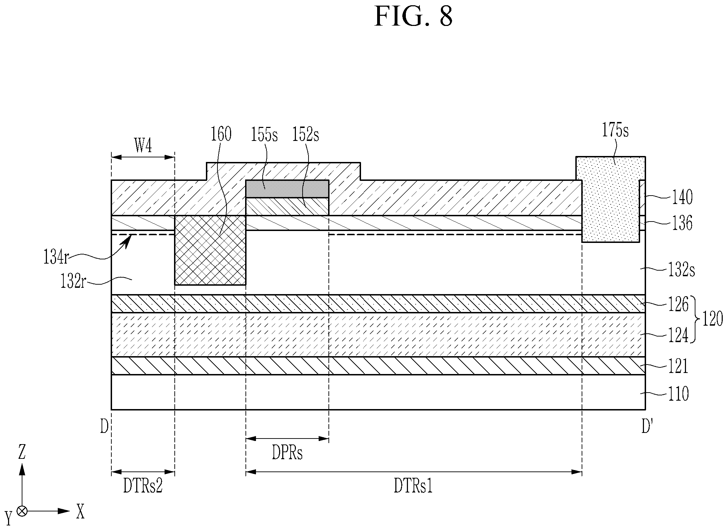

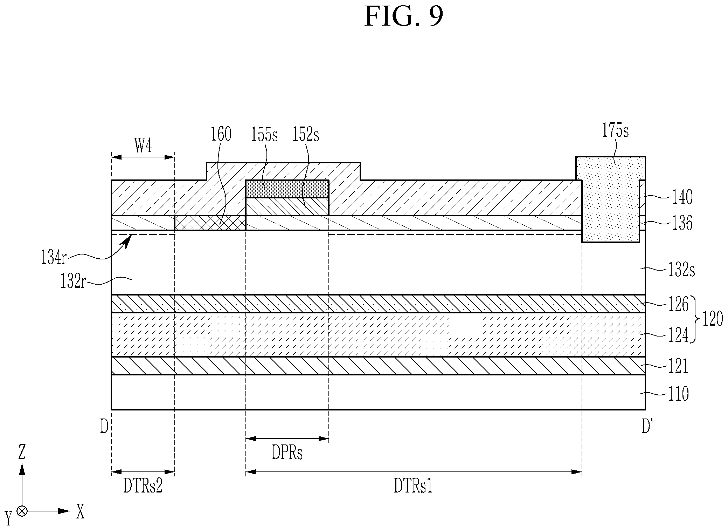

FIG. 5 is a plan view illustrating the peripheral circuit area of the semiconductor device according to some embodiments. FIG. 6 is a cross-sectional view taken along line B-B' of FIG. 2. FIG. 7 is a cross-sectional view taken along line C-C' of FIG. 2. FIG. 8 is a cross-sectional view taken along line D-D' of FIG. 2. FIG. 9 is a cross-sectional view which illustrates a semiconductor device according to some embodiments and corresponds to line D-D' of FIG. 2.

Referring to FIG. 2 and FIGS. 5 to 9, the peripheral circuit element 300 of the semiconductor device may include the sub transistor 310 and the resistive element 320.

The sub transistor 310 of the semiconductor device may include a sub channel layer 132s, the barrier layer 136 (which may be positioned on the sub channel layer 132s), a sub gate electrode 155s that is positioned on the barrier layer 136, a gate semiconductor layer 152s that is positioned between the barrier layer 136 and the sub gate electrode 155s, the protective layer 140 (which may be positioned on the barrier layer 136), and a sensing electrode SE and a sub drain electrode 175s that are positioned on the sub channel layer 132s. The sub channel layer 132s may be a portion of channel layer 132 that is positioned in the peripheral circuit area PA. The sub gate electrode 155s may be a portion of gate electrode layer 155 that is positioned in the peripheral circuit area PA. The sub drain electrode 175s may be a portion of drain electrode layer 175 that is positioned in the peripheral circuit area PA.

The sub channel layer 132s may be a layer that forms a channel between the sub drain electrode 175s and the sensing electrode SE, and inside the sub channel layer 132s, a 2DEG region 134s may be positioned. More particularly, the 2DEG region 134s may be located in an area of the sub channel layer 132s that is in relative proximity to an interface between the sub channel layer 132s and the barrier layer 136. The 2DEG region 134s may reside within a sub drift region DTRs1 in the sub channel layer 132s. Like the 2DEG region 134m described above with reference to the main channel layer 132m, the 2DEG region 134s may be a region in the sub channel layer 132s in which the movement of electrons is substantially confined to a two-dimensional sheet (plane) in three-dimensional space, such that the behavior of the electrons can be understood and/or predicted according to a 2-dimensional electron gas model.

In some embodiments, the sub channel layer 132s may be formed integrally with the main channel layer 132m of the main transistor 100 by the same process. The sub channel layer 132s may be positioned together with the main channel layer 132m in the same layer. The lower surface of the sub channel layer 132s may be positioned at a level with the lower surface of the main channel layer 132m, and the upper surface of the sub channel layer 132s may be positioned at a level with the upper surface of the main channel layer 132m. In other words, the lower surface of the sub channel layer 132s and the lower surface of the main channel layer 132m may be positioned at the same distance from the upper surface of the substrate 110. Further, the upper surface of the sub channel layer 132s and the upper surface of the main channel layer 132m may be positioned at the same distance from the upper surface of the substrate 110. The thickness of the sub channel layer 132s in a third direction (a Z direction) may be substantially the same as the thickness of the main channel layer 132m in the third direction (the Z direction), however, the present disclosure is not limited thereto. The sub channel layer 132s and the main channel layer 132m may be separated by the separation structure 160, which is further described below.

In some embodiments, the sub channel layer 132s may be positioned on one side of the main channel layer 132m. For example, as depicted in FIG. 2, the sub channel layer 132s may be positioned on one side of the main channel layer 132m in the second direction (the Y direction), but is not limited thereto. In this case, a width W2 of the sub channel layer 132s in the second direction (the Y direction) may be different from a width W1 of the main channel layer 132m in the second direction (the Y direction). For example, the width W2 may be smaller than the width W1.

In some embodiments, as depicted in FIG. 5, the sub channel layer 132s may include a portion 132s_P1 that is positioned between the sub gate electrode 155s and the sub drain electrode 175s, and a portion 132s_P2 that is positioned between the sub gate electrode 155s and the sensing electrode SE. In other words, the portion 132s_P1 may be positioned on one side of the sub gate electrode 155s, and the portion 132s_P2 may be positioned on the other side of the sub gate electrode 155s. Here, the portion 132s_P1 may refer to a portion of the sub channel layer 132s that is positioned between the sub gate electrode 155s and the sub drain electrode 175s, and the portion 132s_P2 may refer to a portion of the sub channel layer 132s that is positioned between the sub gate electrode 155s and the sensing electrode SE. The width of the portion 132s_P1 in the second direction (the Y direction) may be the width W2, which may be larger than a width W3 of the portion 132s_P2 in the second direction (the Y direction).

As shown in FIG. 6, one end of the sub channel layer 132s may be in contact with the sub drain electrode 175s. The sub channel layer 132s may be electrically connected to the main drain electrode 175m through the sub drain electrode 175s. The other end of the sub channel layer 132s may be in contact with the sensing electrode SE.

In some embodiments, the sub channel layer 132s may be formed of the same material as that of the main channel layer 132m that is positioned in the main element area MA (e.g., they may be formed from the same layer). As an example, the sub channel layer 132s may contain at least one material selected from III-V materials such as nitrides containing Al, Ga, In, B, or a combination thereof.

The sub channel layer 132s may be positioned on the substrate 110, and between the substrate 110 and the sub channel layer 132s, the seed layer 121 and the buffer layer 120 may be positioned. The substrate 110, the seed layer 121, and the buffer layer 120 are layers necessary to form the sub channel layer 132s, and may be omitted in some cases. In some embodiments, the substrate 110, the seed layer 121, and the buffer layer 120 that are positioned in the peripheral circuit area PA may be formed integrally with the substrate 110, the seed layer 121, and the buffer layer 120 that are positioned in the main element area MA by the same processes, respectively.

The barrier layer 136 may be positioned on the sub channel layer 132s. In other words, the barrier layer 136 that is positioned on the main channel layer 132m may further extend to the upper surface of the sub channel layer 132s. The barrier layer 136 may be positioned directly on the sub channel layer 132s. However, the present disclosure is not limited thereto, and between the sub channel layer 132s and the barrier layer 136, other predetermined layers may be further positioned. The region of the sub channel layer 132s overlapping the barrier layer 136 may become a drift region. Specifically, since the barrier layer 136 is different from the sub channel layer 132s in at least one of the polarization characteristic, the energy band gap, and the lattice constant, the 2DEG region 134s may be induced in the sub channel layer 132s having relatively low electrical polarizability by the barrier layer 136.

As shown in FIG. 6, in the peripheral circuit area PA, the sub channel layer 132s may include the sub drift region DTRs1 between the sensing electrode SE and the sub drain electrode 175s. In other words, the sub drift region DTRs1 may refer to the region of the sub channel layer 132s from one side of the sub channel layer 132s in contact with the sub drain electrode 175s to the sensing electrode SE. The sub drift region DTRs1 may refer to the region of the sub channel layer 132s overlapping the barrier layer 136 between the sensing electrode SE and the sub drain electrode 175s. For example, the boundary between the sub drain electrode 175s and the sub channel layer 132s may be one edge of the sub drift region DTRs1, and the boundary between the sensing electrode SE and the sub channel layer 132s may be the other edge of the sub drift region DTRs1. In other words, the sub drift region DTRs1 may refer to a region in the peripheral circuit area PA between one side of the sub channel layer 132s in contact with the sub drain electrode 175s and the sensing electrode SE, where carriers move. The sub drift region DTRs1 may extend in the first direction (the X direction), but is not limited thereto.

The sub gate electrode 155s may be positioned on the barrier layer 136. The sub gate electrode 155s may overlap a partial region of the barrier layer 136 in the vertical direction (for example, the thickness direction of the sub channel layer 132s). The sub gate electrode 155s may overlap a portion of the sub drift region DTRs1 of the sub channel layer 132s in the vertical direction (for example, the thickness direction of the sub channel layer 132s). The sub gate electrode 155s may be positioned between the sensing electrode SE and the sub drain electrode 175s. The sub gate electrode 155s may be spaced apart from the sensing electrode SE and the sub drain electrode 175s. For example, the sub gate electrode 155s may be positioned closer to the sensing electrode SE than to the sub drain electrode 175s. In other words, the separation distance between the sub gate electrode 155s and the sensing electrode SE may be smaller than the separation distance between the sub gate electrode 155s and the sub drain electrode 175s, however, the present disclosure is not limited thereto.

In some embodiments, the sub gate electrode 155s may be formed integrally with the main gate electrode 155m of the main transistor 100. In other words, the sub gate electrode 155s may be formed integrally with the main gate electrode 155m of the main transistor 100 by the same process. The sub gate electrode 155s may be positioned together with the main gate electrode 155m in the same layer. The lower surface of the sub gate electrode 155s may be positioned at a level with the lower surface of the main gate electrode 155m, and the upper surface of the sub gate electrode 155s may be positioned at a level with the upper surface of the main gate electrode 155m. In other words, the lower surface of the sub gate electrode 155s and the lower surface of the main gate electrode 155m may be positioned at the same distance from the upper surface of the substrate 110. The thickness of the sub gate electrode 155s in the third direction (the Z direction) may be substantially the same as the thickness of the main gate electrode 155m in the third direction (the Z direction), however, the present disclosure is not limited thereto.

The sub gate electrode 155s may contain a conductive material. The sub gate electrode 155s may be formed of the same material as that of the main gate electrode 155m (e.g., they may be formed from the same conductive layer). However, the sub gate electrode 155s is not limited thereto, and may contain a material different from that of the main gate electrode 155m.

The gate semiconductor layer 152s may be positioned between the barrier layer 136 and the sub gate electrode 155s. In some examples, the gate semiconductor layer 152s and the gate semiconductor layer 152m may represent respective portions of the same gate semiconductor layer that extends in the second direction (the Y direction) and is both positioned between the barrier layer 136 and the main gate electrode 155m and positioned between the barrier layer 136 and the sub gate electrode 155s. The gate semiconductor layer 152s may overlap the sub gate electrode 155s in the vertical direction (for example, the thickness direction of the sub channel layer 132s). Also, the gate semiconductor layer 152s may overlap the main gate electrode 155m and the separation structure 160 in the vertical direction (for example, the thickness direction of the sub channel layer 132s), however, the present disclosure is not limited thereto. The sub gate electrode 155s may be brought into Schottky contact or ohmic contact with the gate semiconductor layer 152s. The structural shapes of the gate semiconductor layer 152s and the sub gate electrode 155s may be substantially the same as the structural shapes of the gate semiconductor layer 152m and the main gate electrode 155m. However, the present disclosure is not limited thereto. In some examples, the gate semiconductor layer 152s may be omitted from the sub transistor 310, and the lower surface of the sub gate electrode 155s may be in contact with the barrier layer 136.

The gate semiconductor layer 152s may be positioned between the sensing electrode SE and the sub drain electrode 175s. The gate semiconductor layer 152s may be spaced apart from the sensing electrode SE and the sub drain electrode 175s. The gate semiconductor layer 152s may be positioned closer to the sensing electrode SE than to the sub drain electrode 175s. In other words, the separation distance between the gate semiconductor layer 152s and the sensing electrode SE may be smaller than the separation distance between the gate semiconductor layer 152s and the sub drain electrode 175s, however, the present disclosure is not limited thereto.

A depletion region DPRs may be formed inside the sub channel layer 132s by the gate semiconductor layer 152s. The depletion region DPRs may be positioned inside the sub drift region DTRs1. Here, the depletion region DPRs may refer to a region in the sub drift region DTRs1 where the flow of electrons in the 2DEG region 134s is cut. As the depletion region DPRs is generated, no current may flow between the sensing electrode SE and the sub drain electrode 175s, and the channel path may be blocked.

The protective layer 140 may be positioned on the barrier layer 136. The lower surface of the protective layer 140 may be in contact with the barrier layer 136. In some embodiments, the protective layer 140 may be formed integrally with the protective layer 140 of the main element area MA by the same process. In other words, the protective layer 140 may be positioned on the barrier layer 136 of the main element area MA and the barrier layer 136 of the peripheral circuit area PA.

The sub drain electrode 175s and the sensing electrode SE may be positioned on opposite sides of the sub channel layer 132s, respectively. The sub drain electrode 175s and the sensing electrode SE may be in contact with the sub channel layer 132s, and may be electrically connected to the sub channel layer 132s. The sub drain electrode 175s and the sensing electrode SE may be positioned on the outside of the sub drift region DTRs1. The interface between the sub drain electrode 175s and the sub channel layer 132s may be one edge of the sub drift region DTRs1. Similarly, the interface between the sensing electrode SE and the sub channel layer 132s may be the other edge of the sub drift region DTRs1.

The sub drain electrode 175s may extend in the second direction (the Y direction) from one end of the main drain electrode 175m. The sensing electrode SE may be an electrode corresponding to the node N4 where the resistive element 320 and the sensing unit 500 are connected. Accordingly, the sensing voltage $V_{CS}$ may be transferred to the resistive element 320 and the sensing unit 500 through the sensing electrode SE.

In some embodiments, the sub drain electrode 175s and the sensing electrode SE may be positioned inside spaces formed by recessing at least some portions of the sub channel layer 132s. The sub drain electrode 175s and the sensing electrode SE may pass through the barrier layer 136 so as to be in contact with the side surface of the sub channel layer 132s. The sub drain electrode 175s and the sensing electrode SE may be electrically connected to the sub drift region DTRs1. However, the present disclosure is not limited thereto, and the sub channel layer 132s may not be recessed, and the sub drain electrode 175s and the sensing electrode SE may be positioned on the upper main surface of the sub channel layer 132s.

The sub drain electrode 175s and the sensing electrode SE may cover at least some portions of the upper surface of the protective layer 140, but are not limited thereto. Also, the sub drain electrode 175s and the sensing electrode SE may cover at least some portions of the side surface of the protective layer 140. For example, the sub drain electrode 175s and the sensing electrode SE may cover the side surface of the protective layer 140. The upper surface of the sub drain electrode 175s and the upper surface of the sensing electrode SE may protrude from the upper surface of the protective layer 140.

The sub drain electrode 175s and the sensing electrode SE may contain a conductive material. The sub drain electrode 175s and the sensing electrode SE may be formed of the same material (e.g., each a pattern from the same conductive layer). Also, the sub drain electrode 175s and the sensing electrode SE may be formed of the same material as that of the main source electrode 173m and the main drain electrode 175m (e.g., each a pattern of the same conductive layer). The sub drain electrode 175s and the sensing electrode SE may be formed together with the main source electrode 173m and the main drain electrode 175m by the same process. For example, the main drain electrode 175m and the sensing electrode SE may contain a metal, a metal alloy, a conductive metal nitride, a metal silicide, a doped semiconductor material, a conductive metal oxide, a conductive metal oxynitride, or the like. The main drain electrode 175m and the sensing electrode SE may include a single layer or multiple layers. The main drain electrode 175m and the sensing electrode SE may be in ohmic contact with the sub channel layer 132s. The region in the sub channel layer 132s which is in contact with the sensing electrode SE may be doped at a relatively higher concentration as compared to the other region, however, the present disclosure is not limited thereto.

The resistive element 320 of the semiconductor device may include a channel pattern 132r that is positioned between the sensing electrode SE and the main source electrode 173m. The resistive element 320 may also include the barrier layer 136, which may be positioned on the channel pattern 132r. The resistive element 320 may include a drift region resistance RD of a sub drift region DTRs2 in the channel pattern 132r, a contact resistance RC1 at a contact interface CI1 between the channel pattern 132r and the sensing electrode SE, and a contact resistance RC2 at a contact interface CI2 between the channel pattern 132r and the main source electrode 173m. The channel pattern 132r may be a portion of channel layer 132 that is positioned in the peripheral circuit area PA, between the sensing electrode SE and the main source electrode 173m.

The channel pattern 132r may be a layer that forms a channel between the sensing electrode SE and the main source electrode 173m, and inside the channel pattern 132r, a 2DEG region 134r may be positioned. More particularly, the 2DEG region 134r may be located in an area of the channel pattern 132r that is in relative proximity to an interface between the channel pattern 132r and the barrier layer 136. The 2DEG region 134r may reside within the sub drift region DTRs2 in the channel pattern 132r. Like the 2DEG regions 134m and 134s described above with reference to the main channel layer 132m and the sub channel layer 132s, respectively, the 2DEG region 134r may be a region in the channel pattern 132r in which the movement of electrons is substantially confined to a two-dimensional sheet (plane) in three-dimensional space, such that the behavior of the electrons can be understood and/or predicted according to a 2-dimensional electron gas model.

In some embodiments, the channel pattern 132r may be formed integrally with the main channel layer 132m of the main transistor 100 and the sub channel layer 132s of the sub transistor 310 by the same process. The channel pattern 132r may be positioned together with the main channel layer 132m and the sub channel layer 132s in the same layer. The lower surface of the channel pattern 132r may be positioned at a level with the lower surface of the main channel layer 132m and the lower surface of the sub channel layer 132s, and the upper surface of the channel pattern 132r may be positioned at a level with the upper surface of the main channel layer 132m and the upper surface of the sub channel layer 132s. In other words, the lower surface of the channel pattern 132r, the lower surface of the main channel layer 132m, and the lower surface of the sub channel layer 132s may be positioned at the same distance from the upper surface of the substrate 110. Also, the upper surface of the channel pattern 132r, the upper surface of the main channel layer 132m, and the upper surface of the sub channel layer 132s may be positioned at the same distance from the upper surface of the substrate 110. The thickness of the channel pattern 132r in the third direction (the Z direction) may be substantially the same as the thickness of the main channel layer 132m in the third direction (the Z direction), however, the present disclosure is not limited thereto. Also, the thickness of the channel pattern 132r in the third direction (the Z direction) may be substantially the same as the thickness of the sub channel layer 132s in the third direction (the Z direction), however, the present disclosure is not limited thereto. The separation structure 160 may separate the channel pattern 132r and the sub channel layer 132s, and may separate the channel pattern 132r and the main channel layer 132m.

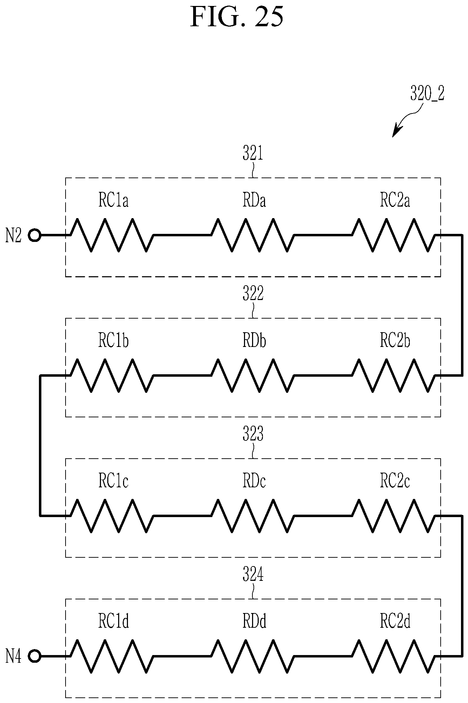

The channel pattern 132r may be positioned on one side of the sub channel layer 132s. The channel pattern 132r may be positioned between the sensing electrode SE and the main source electrode 173m. For example, the main source electrode 173m may further extend to the peripheral circuit area PA so as to be in contact with one side of the channel pattern 132r. One end of the channel pattern 132r may be electrically connected to the main source electrode 173m. The other end of the channel pattern 132r may be in contact with the sensing electrode SE. As an example, the channel pattern 132r may extend in the second direction (the Y direction) between the sensing electrode SE and the main source electrode 173m. However, the channel pattern 132r is not limited thereto, and may include a portion extending in the first direction (the X direction) and a portion extending in the second direction (the Y direction). Also, the channel pattern 132r may include a plurality of patterns extending in the first direction (the X direction). This will be described below with reference to FIGS. 25 to 34.

In some embodiments, the width of the channel pattern 132r may be smaller than the width of the sub channel layer 132s. For example, a width W4 of the channel pattern 132r in the first direction (the X direction) may be smaller than the width of the sub channel layer 132s in the second direction (the Y direction). The width W4 of the channel pattern 132r in the first direction (the X direction) may be smaller than the width W3 of the portion 132s_P2 of the sub channel layer 132s in the second direction (the Y direction). Also, the width W4 of the channel pattern 132r in the first direction (the X direction) may be smaller than the width W2 of the portion 132s_P1 of the sub channel layer 132s in the second direction (the Y direction). Further, the width W4 of the channel pattern 132r in the first direction (the X direction) may be smaller than the width W1 of the main channel layer 132m in the second direction (the Y direction). The width W4 of the channel pattern 132r in the first direction (the X direction) may be selected so that the resistive element 320 of the semiconductor device has a resistance value in an appropriate range.

Also, the width W4 of the channel pattern 132r in the first direction (the X direction) may be substantially the same as the width of the main source electrode 173m in the first direction (the X direction). Further, the width of the sensing electrode SE in the first direction (the X direction) may be substantially the same as the width W4 of the channel pattern 132r in the first direction (the X direction). However, the present disclosure is not limited thereto, and for example, the width of the main source electrode 173m in the first direction (the X direction) or the width of the sensing electrode SE in the first direction (the X direction) may be smaller than the width of the channel pattern 132r in the first direction (the X direction). As another example, the width of the main source electrode 173m in the first direction (the X direction) or the width of the sensing electrode SE in the first direction (the X direction) may be larger than the width of the channel pattern 132r in the first direction (the X direction). In this case, the sensing electrode SE may overlap the separation structure 160 in the third direction (the Z direction), however, the present disclosure is not limited thereto.

In some embodiments, the channel pattern 132r may be formed of the same material as that of the main channel layer 132m and the sub channel layer 132s (e.g., each a pattern of the same conductive layer). As an example, the channel pattern 132r may contain at least one material selected from III-V materials such as nitrides containing Al, Ga, In, B, or a combination thereof. The channel pattern 132r may be positioned on the substrate 110, and between the substrate 110 and the channel pattern 132r, the seed layer 121 and the buffer layer 120 may be positioned. The substrate 110, the seed layer 121, and the buffer layer 120 may be layers necessary for forming the channel pattern 132r, and may be omitted in some cases.

The barrier layer 136 may be positioned on the channel pattern 132r. In other words, the barrier layer 136 that is positioned on the main channel layer 132m may further extend to the upper surface of the channel pattern 132r. The barrier layer 136 may be positioned directly on the channel pattern 132r. However, the present disclosure is not limited thereto, and between the channel pattern 132r and the barrier layer 136, other predetermined layers may be further positioned. The region of the channel pattern 132r overlapping the barrier layer 136 may become a drift region.

Referring to FIG. 7 together, in the peripheral circuit area PA, the channel pattern 132r may include the sub drift region DTRs2 between the sensing electrode SE and the main source electrode 173m. In other words, the sub drift region DTRs2 may refer to a region of the channel pattern 132r from one side of the channel pattern 132r in contact with the main source electrode 173m to the sensing electrode SE. The sub drift region DTRs2 may refer to the region of the channel pattern 132r overlapping the barrier layer 136 between the sensing electrode SE and the main source electrode 173m. For example, the boundary between the main source electrode 173m and the channel pattern 132r may be one edge of the sub drift region DTRs2, and the boundary between the sensing electrode SE and the channel pattern 132r may be the other edge of the sub drift region DTRs2. In other words, the sub drift region DTRs2 may refer to a region in the peripheral circuit area PA between one side of the channel pattern 132r in contact with the main source electrode 173m and the sensing electrode SE, where carriers move. The sub drift region DTRs2 may extend in the second direction (the Y direction), but is not limited thereto.

The sub drift region DTRs2 may have a resistance component. In other words, the region of the channel pattern 132r from the main source electrode 173m to the sensing electrode SE may have an associated resistance. The sub drift region DTRs2 may serve as a portion of the resistance of the resistive element 320 of the semiconductor device. In some embodiments, the drift region resistance RD of the sub drift region DTRs2 may have a positive temperature coefficient of resistance (TCR). For example, the temperature coefficient of resistance of the sub drift region DTRs2 may be about 5 ($\Omega/\mu$m°C) to about 15 ($\Omega/\mu$m°C). Accordingly, the drift region resistance RD of the sub drift region DTRs2 may increase as the temperature rises.

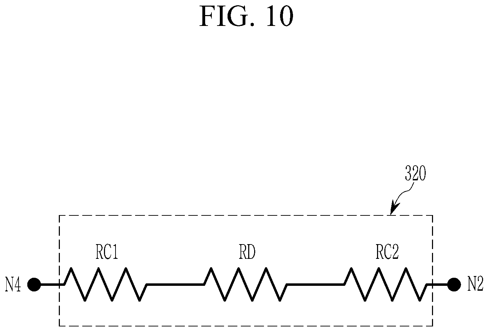

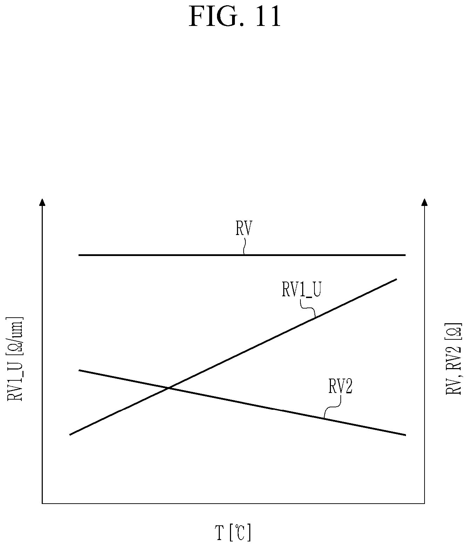

The sub drift region DTRs2 may extend in the second direction (the Y direction). In some embodiments, the length LT of the sub drift region DTRs2 in the second direction (the Y direction) may be 1 $\mu$m to 10 $\mu$m. Preferably, the length LT of the sub drift region DTRs2 in the second direction (the Y direction) may be 3 $\mu$m to 4 $\mu$m. In this range, the resistance value (reference symbol "RV" in FIG. 11) of the resistive element 320 of the semiconductor device according to the embodiment may have a substantially constant value regardless of temperature. This will be described below in detail with reference to FIGS. 10 and 11.

The sensing electrode SE and the main source electrode 173m may be in ohmic contact with the channel pattern 132r. In this case, the contact interface CI1 between the sensing electrode SE and the channel pattern 132r and the contact interface CI2 between the main source electrode 173m and the channel pattern 132r may have resistance components. Specifically, while carriers passing through the 2DEG region 134r are transferred to the sensing electrode SE through at least a portion of the channel pattern 132r, such as an upper portion of the 2DEG region 134r, the contact interface CI1 between the sensing electrode SE and the channel pattern 132r and the contact interface CI2 between the main source electrode 173m and the channel pattern 132r may have associated resistances. Hereinafter, for ease of explanation, the resistance of the contact interface CI1 between the sensing electrode SE and the channel pattern 132r will be referred to as contact resistance RC1, and the resistance of the contact interface CI2 between the main source electrode 173m and the channel pattern 132r will be referred to as contact resistance RC2.

In some embodiments, the contact resistance RC1 and the contact resistance RC2 may differ in value depending on the temperature. For example, the contact resistance RC1 and the contact resistance RC2 may decrease as the temperature rises. In other words, the contact resistance RC1 and the contact resistance RC2 may have negative temperature coefficients of resistance (TCRs). This will be described below in detail with reference to FIGS. 10 and 11.

In some embodiments, the peripheral circuit element 300 may be separated from the main transistor 100 by the separation structure 160. In other words, between the peripheral circuit element 300 and the main transistor 100, the separation structure 160 may be positioned. For example, as shown in FIG. 2, the main transistor 100 and the sub transistor 310 may be positioned so as to be spaced apart from each other in the second direction (the Y direction) by the separation structure 160, but are not limited thereto.

In some embodiments, the separation structure 160 may pass through the barrier layer 136. For example, as shown in FIG. 8, the separation structure 160 may pass through the barrier layer 136 and recess at least a portion of the sub channel layer 132s. Accordingly, the sub drift region DTRs1 of the peripheral circuit element 300 may be electrically insulated from the main transistor 100. However, the present disclosure is not limited thereto, and as another example, as shown in FIG. 9, the separation structure 160 may pass through only the barrier layer 136. As a further example, the separation structure 160 may pass through the barrier layer 136 and the sub channel layer 132s. As a still further example, the peripheral circuit element 300 and the main transistor 100 may be separated by a trench passing through at least a portion of at least one of the sub channel layer 132s and the main channel layer 132m.

Also, the separation structure 160 may separate the sub transistor 310 and the resistive element 320 and separate the resistive element 320 and the main transistor 100. The separation structure 160 may be positioned between the sub transistor 310 and the resistive element 320 and between the resistive element 320 and the main transistor 100. For example, as shown in FIG. 2, the separation structure 160 may be positioned between the sub channel layer 132s of the sub transistor 310 and the channel pattern 132r of the resistive element 320 and between the main transistor 100 and the resistive element 320. In other words, the separation structure 160 may perform a function of separating the main channel layer 132m, the sub channel layer 132s, and the channel pattern 132r. In this case, as shown in FIG. 7, the separation structure 160 may overlap the main source electrode 173m in the third direction (the Z direction). Also, the separation structure 160 may overlap the main gate electrode 155m and the main drain electrode 175m in the third direction (the Z direction).

In some embodiments, the separation structure 160 may be formed by forming the barrier layer 136 on the main channel layer 132m and the sub channel layer 132s and performing a process of implanting ions into the barrier layer 136 positioned between the main transistor 100 and the peripheral circuit element 300. For example, in the region of the channel layer 132 overlapping the region of the barrier layer 136 subjected to the ion implantation process in the third direction (the Z direction), electrons may not generally behave in accordance with a 2-dimensional electron gas model. In this case, the region of the barrier layer 136 subjected to the ion implantation and the region of the channel layer 132 corresponding thereto may correspond to the separation structure 160. As another example, the separation structure 160 may be formed by performing an ion implantation process on the channel layer 132. The region of the channel layer 132 subjected to the ion implantation may correspond to the separation structure 160, and electrons in the region of the channel layer 132 subjected to the ion implantation process may not generally behave in accordance with a 2-dimensional electron gas model. The material which is used in the ion implantation process may be argon (Ar) ions. However, the present disclosure is not limited thereto, and the separation structure 160 may be formed by forming the barrier layer 136 on the main channel layer 132m and the sub channel layer 132s, forming a trench so as to pass through the barrier layer 136, and filling the trench with an insulating material. The insulating material constituting the separation structure 160 may be formed of the same material as that of the protective layer 140. For example, the insulating material constituting the separation structure 160 may contain an oxide such as $SiO_2$, $Al_2O_3$, etc. As another example, the insulating material constituting the separation structure 160 may contain a nitride such as SiN, or an oxynitride such as SiON. However, the insulating material constituting the separation structure 160 is not limited thereto, and may contain a material different from that of the protective layer 140. In this case, at least a portion of at least one of the main channel layer 132m and the sub channel layer 132s may be recessed as well.

Hereinafter, the resistive element 320 of the semiconductor device according to various embodiments will be described with reference to FIGS. 10 and 11.

FIG. 10 is a circuit diagram illustrating the resistive element 320 according to some embodiments. FIG. 11 is a graph illustrating the resistance value of the resistive element as temperature changes according to some embodiments.

Referring to FIG. 10, the resistive element 320 of the semiconductor device according to the embodiment may include a resistance component having a predetermined resistance value. In the embodiment, the resistive element 320 may be formed of the resistance RD of the sub drift region DTRs2, the contact resistance RC1 at the contact interface CI1 between the channel pattern 132r and the sensing electrode SE, and the contact resistance RC2 at the contact interface CI2 between the channel pattern 132r and the main source electrode 173m. Through the contact resistance RC1, the resistance RD of the sub drift region DTRs2, and the contact resistance RC2 that are included in the resistive element 320, the node N4 and the node N2 may be electrically connected. In this case, the sensing electrode SE may correspond to the node N4, and the portion of the main source electrode 173m positioned in the peripheral circuit area PA may correspond to the node N2.

The contact resistance RC1, the resistance RD of the sub drift region DTRs2, and the contact resistance RC2 may be connected in series. In other words, between the node N4 and the node N2, the contact resistance RC1, the resistance RD of the sub drift region DTRs2, and the contact resistance RC2 may be connected in series. Accordingly, the resistance value RV of the resistive element 320 may be defined as the sum of the contact resistance RC1, the resistance RD of the sub drift region DTRs2, and the contact resistance RC2. This may be due to the structural characteristic in which the sub drift region DTRs2 formed by the channel pattern 132r and the barrier layer 136 is positioned between a contact electrode CT1 and a contact electrode CT2.

Referring to FIG. 11, the resistance value RV of the resistive element 320 of the semiconductor device according to some embodiments may have a substantially constant value regardless of the temperature. In other words, the sum of the contact resistance RC1, the resistance RD of the sub drift region DTRs2, and the contact resistance RC2 connected in series between the node N4 and the node N2 may have a substantially constant value regardless of the temperature. For example, the resistance value RV of the resistive element 320 at a first temperature may be substantially the same as the resistance value RV of the resistive element 320 at a second temperature different from the first temperature.

However, each of the contact resistance RC1, the resistance RD of the sub drift region DTRs2, and the contact resistance RC2 may have different resistance values depending on the temperature.

For example, the resistance value RV2 of each of the contact resistance RC1 and the contact resistance RC2 depending on the temperature has the relationship of the following Equation 1.

$$(Equation\ 1)$$
$$RV2 = A_1 T + K_1\ [\Omega/um]$$

Here, RV2 represents the resistance value (Q) of the contact resistance RC1 and/or the contact resistance RC2, and T represents temperature (°C), and A1 representing the temperature coefficient of resistance (TCR) of the contact resistance RC1 or the contact resistance RC2. Further, K1 is a constant. In this case, the temperature coefficients of resistance (TCRs) of the contact resistance RC1 and the contact resistance RC2 may have negative values. For example, the temperature coefficients of resistance (TCRs) of the contact resistance RC1 and the contact resistance RC2 may be about -20 $\Omega$/°C to about -10 $\Omega$/°C. Accordingly, the contact resistance RC1 and the contact resistance RC2 may decrease as the temperature rises.

In addition, the unit resistance value RV1_U of the sub drift region DTRs2 depending on the temperature has the relationship of the following Equation 2.

$$(Equation\ 2)$$
$$RV1\_U = A_2 T + K_2\ [\Omega/um]$$

Here, RV1_U represents the unit resistance (Q) of the sub drift region DTRs2 per unit length ($\mu$m), and T represents the temperature (°C), and A2 represents the temperature coefficient of resistance (TCR) of the sub drift region DTRs2. Further, K2 is a constant. The unit resistance value RV1_U of the sub drift region DTRs2 may refer to the resistance value of the resistance RD of the sub drift region DTRs2 per unit length. In this case, the temperature coefficient of resistance of the sub drift region DTRs2 may have a positive value. For example, the temperature coefficient of resistance of the sub drift region DTRs2 may be about 5 ($\Omega/\mu$m°C) to about 15 ($\Omega/\mu$m°C). Accordingly, the resistance RD of the sub drift region DTRs2 may increase as the temperature rises. The temperature coefficient of resistance of the sub drift region DTRs2 may be smaller than the temperature coefficient of resistance (TCR) of the contact resistance RC1, however, the present disclosure is not limited thereto.

The resistance RD of the sub drift region DTRs2 may be calculated by multiplying the unit resistance value RV1_U of the sub drift region DTRs2 by the length of the sub drift region DTRs2. As an example, when the length LT of the sub drift region DTRs2 in the second direction (the Y direction) is 1 μm to 10 μm, the resistance RD of the sub drift region DTRs2 may be one time to ten times the unit resistance value RV1_U of the sub drift region DTRs2. In other words, the resistance of the sub drift region DTRs2 may be expressed as the following Equation 3.

(Equation 3)

$$RD = (LT)RV1\_U = (LT)A_2 T + (LT)K_2 \ [\Omega / um]$$

Here, RD may represent the resistance (Ω) of the sub drift region DTRs2, and LT may represent the length (μm) of the sub drift region DTRs2 in the second direction (the Y direction).

In other words, the amount of change in the resistance RD of the sub drift region DTRs2 with respect to an amount of change in the temperature may depend on the temperature coefficient of resistance of the sub drift region DTRs2 and the length LT of the sub drift region DTRs2 in the second direction (the Y direction). Meanwhile, the amounts of change in the contact resistance RC1 and the contact resistance RC2 with respect to a change in the temperature may depend on the temperature coefficients of resistance of the contact resistance RC1 and the contact resistance RC2.

In some embodiments, even though the contact resistance RC1 and the contact resistance RC2 have negative temperature coefficients of resistance and the sub drift region DTRs2 has a positive temperature coefficient of resistance, when the length LT of the sub drift region DTRs2 in the second direction (the Y direction) falls within a range of lengths, the resistance value RV of the resistive element 320 may have a substantially constant value regardless of the temperature. For example, when the length LT of the sub drift region DTRs2 in the second direction (the Y direction) is 1 μm to 10 μm, the temperature coefficient of resistance of the resistance value RV of the resistive element 320 may be about 0 Ω/°C. Preferably, the length LT of the sub drift region DTRs2 in the second direction (the Y direction) may be 3 μm to 4 μm.

Accordingly, even when each of the contact resistance RC1, the resistance RD of the sub drift region DTRs2, and the contact resistance RC2 in the resistive element 320 of the semiconductor device has different resistance values depending on the temperature, the resistance value RV of the resistive element 320 may have a substantially constant value. Therefore, uniform element characteristics (such as the magnitude of the sensing voltage Vcs and the like) can be exhibited regardless of the ambient temperature, and the reliability of the semiconductor device can be improved.

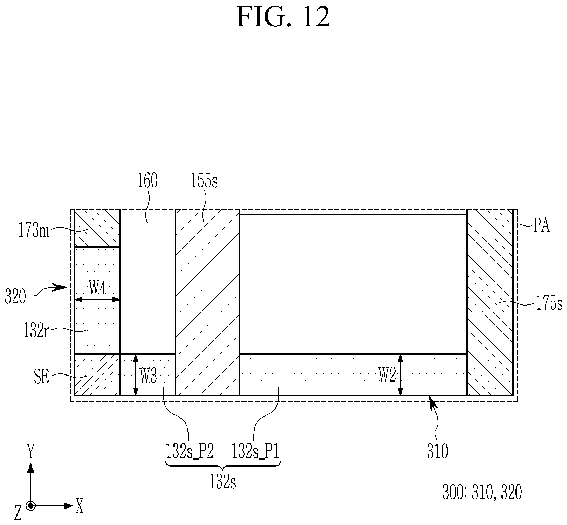

Hereinafter, examples of resistive elements of semiconductor devices according to some embodiments will be described with reference to FIGS. 12 to 19.

FIGS. 12 to 19 are plan views illustrating peripheral circuit elements of semiconductor devices according to some embodiments.

FIGS. 12 to 19 illustrate various modifications of the semiconductor device discussed above with reference to FIGS. 1 to 11. Since the example embodiments shown in FIGS. 12 to 19 have many portions similar to or matching those of the example embodiments shown in FIGS. 1 to 11, a description thereof will not be made and the differences will be mainly described. Constituent elements identical to those discussed above with reference to FIGS. 1 to 11 are denoted by the same reference symbols.

Referring to FIG. 12, in semiconductor devices according to some embodiments, the width of the sub channel layer 132s of the sub transistor 310 may be variously changed. For example, in some embodiments, the width W2 of the portion 132s_P1 of the sub channel layer 132s, positioned between the sub gate electrode 155s and the sub drain electrode 175s, in the second direction (the Y direction) may be substantially the same as the width W3 of the portion 132s_P2 of the sub channel layer 132s, positioned between the sub gate electrode 155s and the sensing electrode SE, in the second direction (the Y direction). In some such embodiments, the width W2 of the portion 132s_P1 of the sub channel layer 132s in the second direction (the Y direction) may be substantially the same as the width W4 of the channel pattern 132r in the first direction (the X direction), however, the present disclosure is not limited thereto.

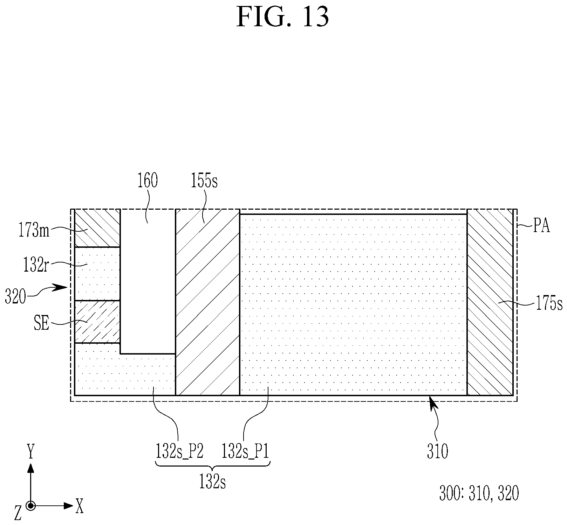

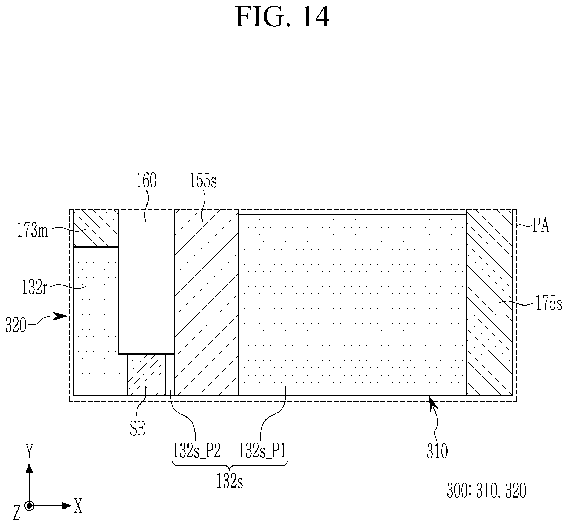

Referring to FIGS. 13 and 14, in semiconductor devices according to some embodiments, the position of the sensing electrode SE may be variously changed. For example, as shown in FIG. 13, the sensing electrode SE may be positioned adjacent to the main source electrode 173m. In this case, one surface of the sensing electrode SE in the first direction (the X direction) may be in contact with the separation structure 160. As another example, as shown in FIG. 14, the sensing electrode SE may be positioned adjacent to the sub gate electrode 155s. In this case, one surface of the sensing electrode SE in the second direction (the Y direction) may be in contact with the separation structure 160.

Accordingly, at least one of the shape of the channel pattern 132r and the shape of the portion 132s_P2 of the sub channel layer 132s may be variously changed. For example, as shown in FIG. 13, the portion 132s_P2 of the sub channel layer 132s may further include a portion that is in contact with the sensing electrode SE and extends in the second direction (the Y direction), or as shown in FIG. 14, the channel pattern 132r may further include a portion that is in contact with the sensing electrode SE and extends in the first direction (the X direction).

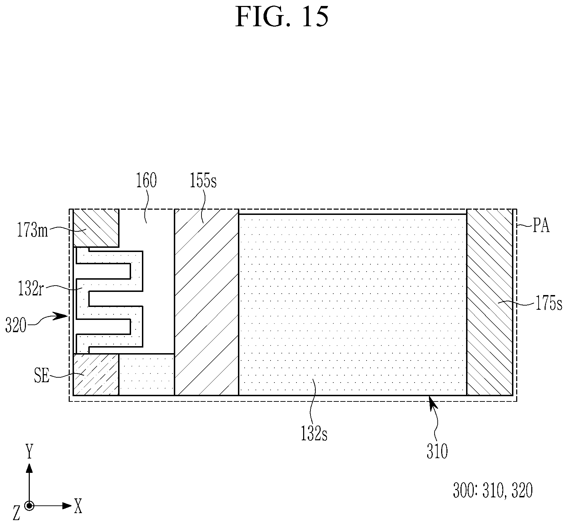

Referring to FIG. 15, the channel pattern 132r may include portions extending in the first direction (the X direction), and portions extending in the second direction (the Y direction). For example, in the channel pattern 132r, the portions extending in the second direction (the Y direction) and the portions extending in the first direction (the X direction) may be alternately positioned from one side of the sensing electrode SE. Such a geometry may be implemented, for instance, to achieve a desired length for the channel pattern 132r within a given area, where the length of the channel pattern 132r is the sum of the lengths of the various portions of the channel pattern 132r. However, this is only illustrative, and the extension direction(s) of the channel pattern 132r are not limited thereto. In an example, the channel pattern 132r may extend only in one dimension from one side of the sensing electrode SE, or may include a plurality of curved portions. Alternatively, the channel pattern 132r may include portions that extend in directions parallel with diagonal directions passing through the intersection of the first direction (the X direction) and the second direction (the Y direction). In an embodiment, the channel pattern 132r may extend so as to have a predetermined length. Here, the extension length of the channel pattern 132r may refer to the sum of the extension lengths of the portions of the channel pattern 132r. In this case, the width of the channel pattern 132r may be smaller than the width of the sub channel layer 132s in the second direction (the Y direction). Here, the width of the channel pattern 132r may refer to the width of the channel pattern 132r in a direction perpendicular to the extension direction of the channel pattern 132r. The width of the main channel layer 132m may refer to the width of the main channel layer 132m in the second direction (the Y direction). In this range, the channel pattern 132r may serve as the resistive element 320.

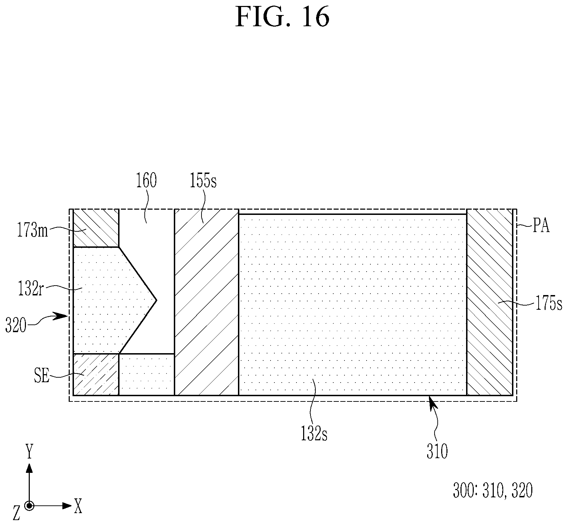

Referring to FIG. 16, in some embodiments, the channel pattern 132r may include a portion whose width in the first direction (the X direction) varies. For example, the channel pattern 132r may include a portion whose width in the first direction (the X direction) increases in a direction away from the sensing electrode SE. Also, the channel pattern 132r may further include a portion whose width in the first direction (the X direction) decreases in a direction away from the sensing electrode SE.

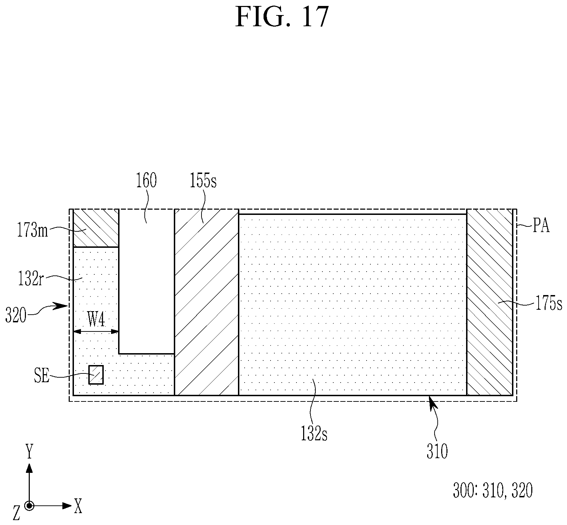

Referring to FIG. 17, in semiconductor devices according to some embodiments, the width of the sensing electrode SE may be different from the width W4 of the channel pattern 132r in the first direction (the X direction). For example, the width of the sensing electrode SE in the first direction (the X direction) may be smaller than the width W4 of the channel pattern 132r in the first direction (the X direction).

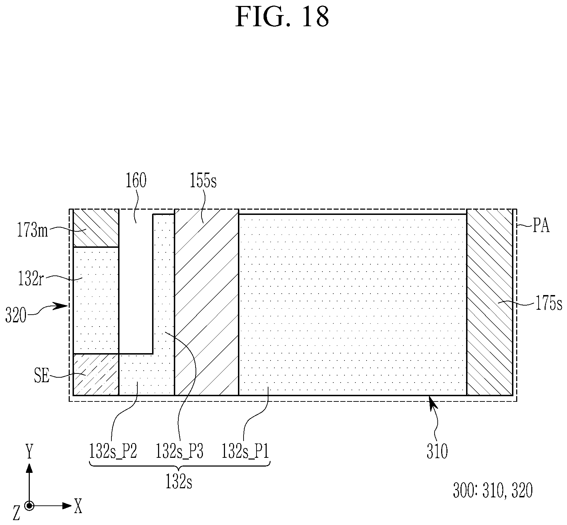

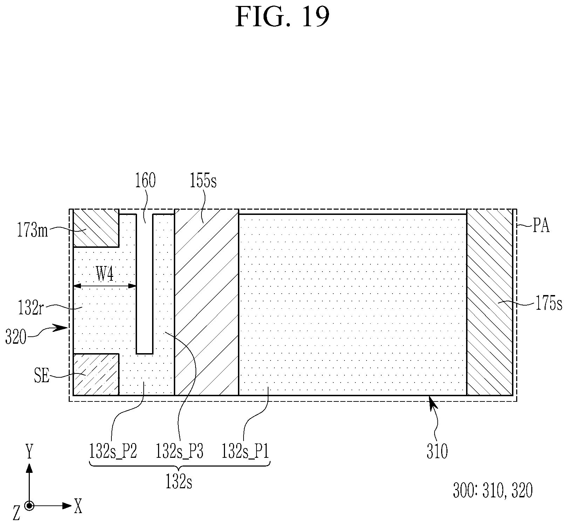

Referring to FIGS. 18 and 19, in semiconductor devices according to some embodiments, the sub channel layer 132s may further include a portion 132s_P3 that is positioned between the portion 132s_P2 and the sub gate electrode 155s. In this case, the width of the portion 132s_P3 in the second direction (the Y direction) may be substantially the same as the width of the portion 132s_P1 in the second direction (the Y direction), and the width of the portion 132s_P3 in the second direction (the Y direction) may be larger than the width of the portion 132s_P2 in the second direction (the Y direction). In some embodiments, one surface of the portion 132s_P3 in the first direction (the X direction) may be in contact with the separation structure 160. Accordingly, the separation structure 160 may be positioned apart from the sub gate electrode 155s in the first direction (the X direction).

As shown in FIG. 19, in semiconductor devices according to some embodiments, the width W4 of the channel pattern 132r in the first direction (the X direction) may be larger than the width of the main source electrode 173m in the first direction (the X direction). Also, the width W4 of the channel pattern 132r in the first direction (the X direction) may be larger than the width of the sensing electrode SE in the first direction (the X direction). In this case, some portions of one surface of the main source electrode 173m in the second direction (the Y direction) and one surface of the main source electrode 173m in the first direction (the X direction) may be in contact with the channel pattern 132r. Accordingly, the area of the contact interface between the main source electrode 173m and the channel pattern 132r may relatively increase.

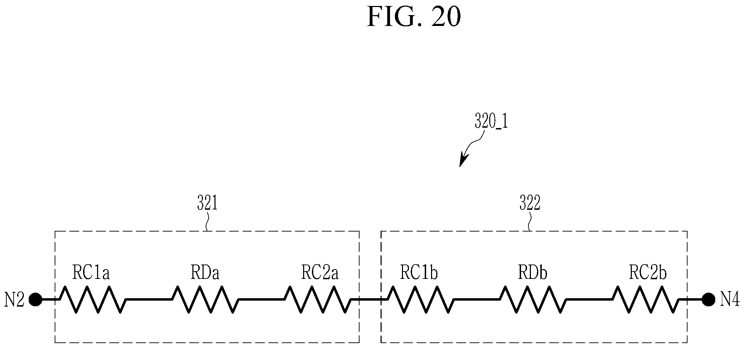

Hereinafter, additional examples of resistive elements of semiconductor devices according to some embodiments will be described with reference to FIGS. 20 to 24.

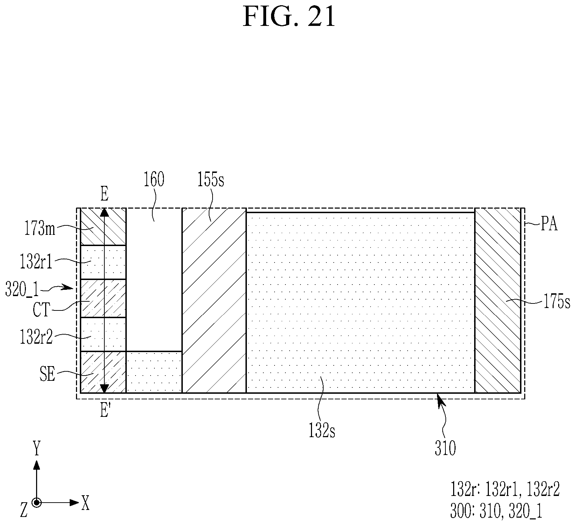

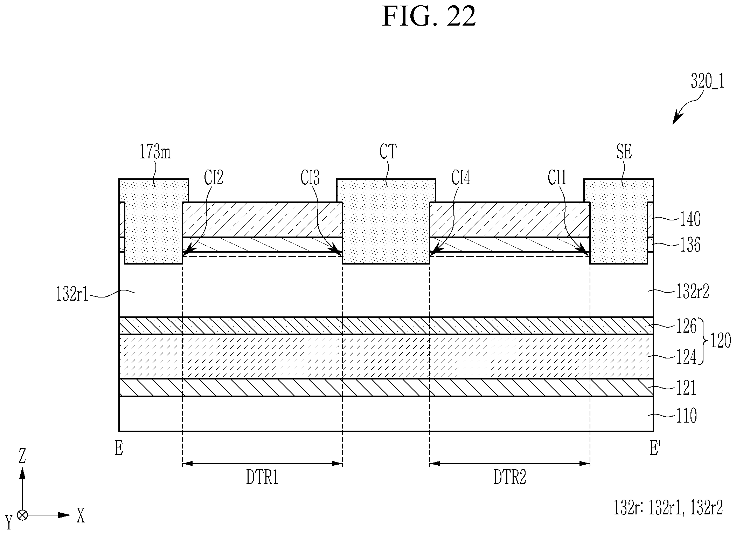

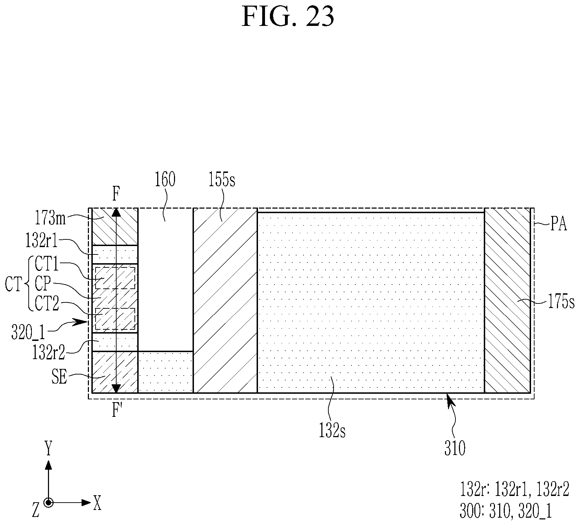

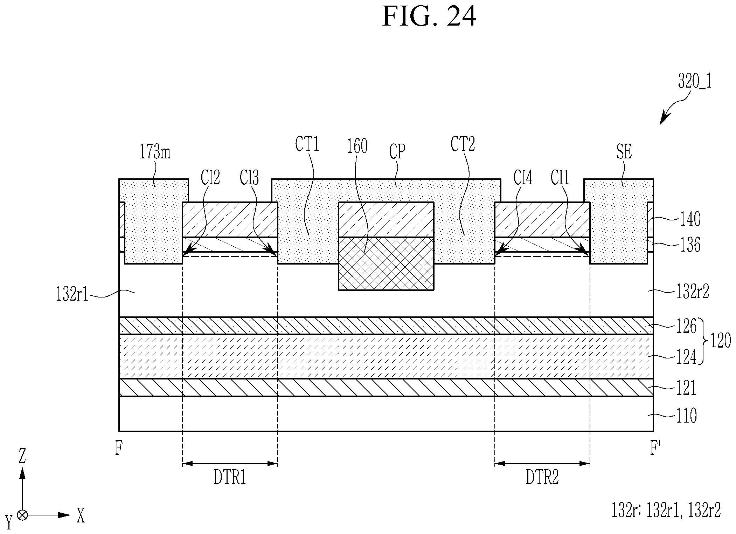

FIG. 20 is a circuit diagram illustrating a resistive element 320_1 of a semiconductor device according to some embodiments. FIG. 21 is a plan view illustrating a peripheral circuit element including the resistive element of FIG. 20. FIG. 22 is a cross-sectional view taken along line E-E' of FIG. 20. FIG. 23 is a plan view illustrating a peripheral circuit element including the resistive element of FIG. 20. FIG. 24 is a cross-sectional view taken along line F-F' of FIG. 23. According to some embodiments, the resistive element 320_1 of FIGS. 20 to 24 may correspond to the resistive element 320 of the embodiment of FIG. 1.

Referring to FIGS. 20 to FIG. 24, the resistive element 320_1 of the semiconductor device according to some embodiments may include a resistive element 321 and a resistive element 322.

First, referring to FIG. 20, the resistive elements 321 and 322 may be connected in series. In other words, the resistive element 321 and the resistive element 322 may be sequentially connected between the node N4 and the node N2. Accordingly, the resistance value of the resistive element 320_1 of the semiconductor device may be the sum of the resistance value of the resistive element 321 and the resistance value of the resistive element 322. Here, the resistance of the resistive element 321 may include a first contact resistance RC1a of the resistive element 321, a drift region resistance RDa of the resistive element 321, and a second contact resistance RC2a of the resistive element 321. The resistance of the resistive element 322 may include a first contact resistance RC1b of the resistive element 322, a drift region resistance RDb of the resistive element 322, and a second contact resistance RC2b of the resistive element 322.

In some embodiments, the resistive element 321 and the resistive element 322 may have substantially constant resistance values regardless of the temperature.

In this case, the drift region resistance RDa and the drift region resistance RDb may have positive temperature coefficients of resistance (TCRs). Accordingly, the drift region resistance RDa and the drift region resistance RDb may increase as the temperature rises.

The contact resistances RC1a and RC2a of the resistive element 321 and the contact resistances RC1b and RC2b of the resistive element 322 may have negative temperature coefficients of resistance (TCRs). Accordingly, the contact resistances RC1a, RC2a, RC1b, and RC2b may decrease as the temperature rises.

As temperature rises, increases in the drift region resistance RDa of the resistive element 321 may be offset by decreases in the contact resistances RC1a and RC2a, such that the overall resistance of the resistive element 321 remains substantially constant. Likewise, increases in the drift region resistance RDb of the resistive element 322 may be offset by decreases in the contact resistances RC1b and RC2b, such that the overall resistance of the resistive element 322 remains substantially constant. Accordingly, since the resistive elements 321 and 322 have substantially constant resistance values regardless of the temperature, even when the resistive elements 321 and 322 are connected, the resistive element 320_1 of the semiconductor device may have a substantially constant resistance value regardless of the temperature. Therefore, by connecting the resistive elements 321 and 322 in various ways, it is possible to easily design elements having substantially constant resistance values regardless of the temperature.

Next, referring to FIGS. 21 and 22, the resistive element 320_1 may further include the contact electrode CT that is positioned on the channel pattern 132r between the main source electrode 173m and the sensing electrode SE. In some embodiments, the channel pattern 132r may include the channel pattern 132r1 that is positioned between the main source electrode 173m and the sensing electrode SE, and the channel pattern 132r2 that is positioned between the contact electrode CT and the sensing electrode SE.

The channel patterns 132r1 and 132r2 may be arranged along one direction. The arrangement direction of the channel patterns 132r1 and 132r2 may be substantially identical to the extension direction of the channel patterns 132r1 and 132r2. For example, as shown in FIG. 21, each of the channel patterns 132r1 and 132r2 may extend in the second direction (the Y direction), and the channel patterns 132r1 and 132r2 may be arranged in the second direction (the Y direction), however, the present disclosure is not limited thereto. In some embodiments, the channel pattern 132r1 and the channel pattern 132r2 may have the same arrangement, shape, structure, material, and the like as those of the channel pattern 132r of FIGS. 1 to 11.

In some embodiments, the channel pattern 132r1 may have the drift region DTR1, and the channel pattern 132r2 may have the drift region DTR2. The resistance of the drift region DTR1 of the channel pattern 132r1 may correspond to the drift region resistance RDa of the resistive element 321 of FIG. 20. The resistance of the drift region DTR2 of the channel pattern 132r2 may correspond to the drift region resistance RDb of the resistive element 322 of FIG. 20. The contact resistance RC1a of the resistive (resistance) element 321 may correspond to the resistance of the contact interface CI2 between the main source electrode 173m and the channel pattern 132r1. The contact resistance RC2b of the resistive (resistance) element 322 may correspond to the resistance of the contact interface CI1 between the sensing electrode SE and the channel pattern 132r2.

In some embodiments, the channel pattern 132r1 and the channel pattern 132r2 may have substantially the same length in the second direction (the Y direction). For example, the length between one side of the channel pattern 132r1 in contact with the main source electrode 173m and the other side of the channel pattern 132r1 in contact with the contact electrode CT may be substantially the same as the length between one side of the channel pattern 132r2 in contact with the contact electrode CT and the other side of the channel pattern 132r2 in contact with the sensing electrode SE.

In some embodiments, the contact electrode CT may be positioned on the channel pattern 132r. The contact electrode CT may be positioned between the main source electrode 173m and the sensing electrode SE. The contact electrode CT may be in contact with the channel pattern 132r, and may be electrically connected to the channel pattern 132r. The contact electrode CT may be positioned in a space formed by recessing at least a portion of the channel pattern 132r. For example, as shown in FIG. 22, the contact electrode CT may completely fill the space formed by recessing at least a portion of the channel pattern 132r, however, the present disclosure is not limited thereto. The contact electrode CT may pass through the barrier layer 136. In some embodiments, the contact electrode CT may be positioned at the same level together with the main source electrode 173m and the sensing electrode SE (e.g., the main source electrode 173m, the sensing electrode SE and the contact electrode CT each may be pattern elements of the same conductive layer), and may be formed concurrently with the main source electrode 173m and the sensing electrode SE by the same process. The contact electrode CT may be formed of the as that of the main source electrode 173m and the sensing electrode SE.

The contact electrode CT may be in ohmic contact with the channel pattern 132r. In this case, a contact interface CI3 between the contact electrode CT and the channel pattern 132r1 and a contact interface CI4 between the contact electrode CT and the channel pattern 132r2 may have resistance components. The contact resistance RC2a of the resistive element 321 may correspond to the resistance of the contact interface CI3, between the sensing electrode SE and the first channel pattern 132r1, and the contact resistance RC1b of the resistive element 322 may correspond to the resistance of the contact interface CI4 between the sensing electrode SE and the second channel pattern 132r2.

The contact resistance RC2a of the resistive element 321 and the contact resistance RC1b of the resistive element 322 may have different values depending on the temperature. For example, the contact resistances RC2a and RC1b may decrease as the temperature rises. In other words, the contact resistances RC2a and RC1b may have negative temperature coefficients of resistance (TCRs).

In some embodiments, the resistance value of each of the resistive elements 321 and 322 may have a substantially constant value regardless of the temperature. In other words, the temperature coefficient of resistance (TCR) of each of the resistive elements 321 and 322 may be about 0. However, the present disclosure is not limited thereto, and the resistance value of each of the resistive elements 321 and 322 may increase or decrease as the temperature rises, and the sum of the resistance values of the resistive elements 321 and 322 may have a substantially constant value regardless of the temperature. As an example, the resistance value of each of the resistive elements 321 and 322 may increase or decrease as the temperature rises.

Referring to FIGS. 23 and 24, the contact electrode CT of the resistive element 320_1 according to some embodiments may include the contact electrode CT1 and the contact electrode CT2. In this case, between the contact electrode CT1 and the contact electrode CT2, a connection portion CP may be further included.

In some embodiments, the contact electrode CT1 and the contact electrode CT2 may be integrally formed. In other words, the contact electrode CT1 and the contact electrode CT2 may be integrally formed in the same process. In this case, the separation structure 160 and the protective layer 140 may be positioned between the contact electrode CT1 and the contact electrode CT2, and the connection portion CP may be positioned on the protective layer 140. The connection portion CP may electrically connect the contact electrode CT1 and the contact electrode CT2. The connection portion CP may be positioned on the protective layer 140. The connection portion CP may cover the upper surface of the protective layer 140. The connection portion CP may overlap the protective layer 140 and the separation structure 160 in the third direction (the Z direction).

Hereinafter, additional examples of resistive elements of semiconductor devices according to some embodiments will be described with reference to FIGS. 25 to 34.

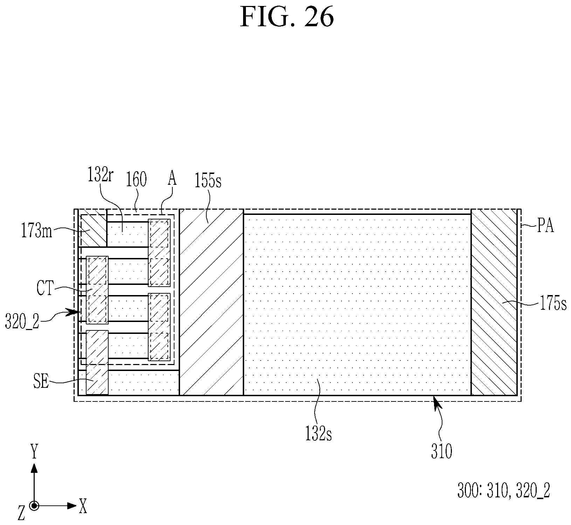

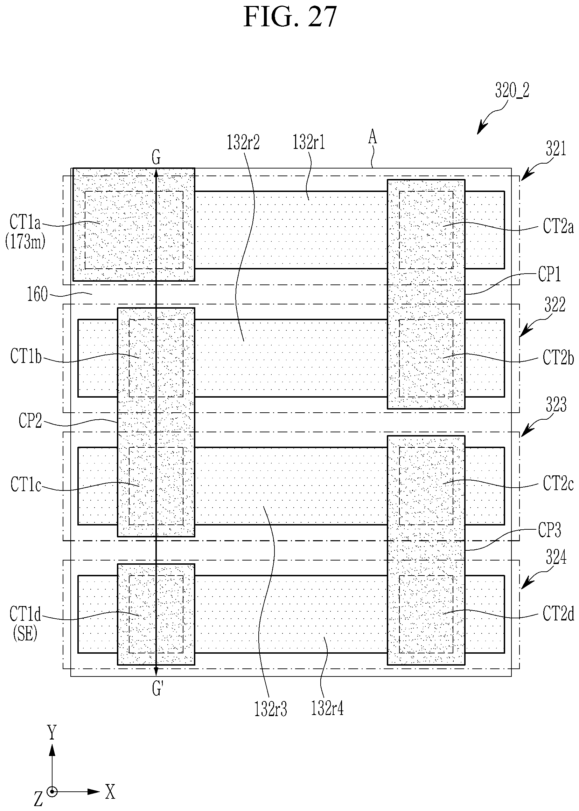

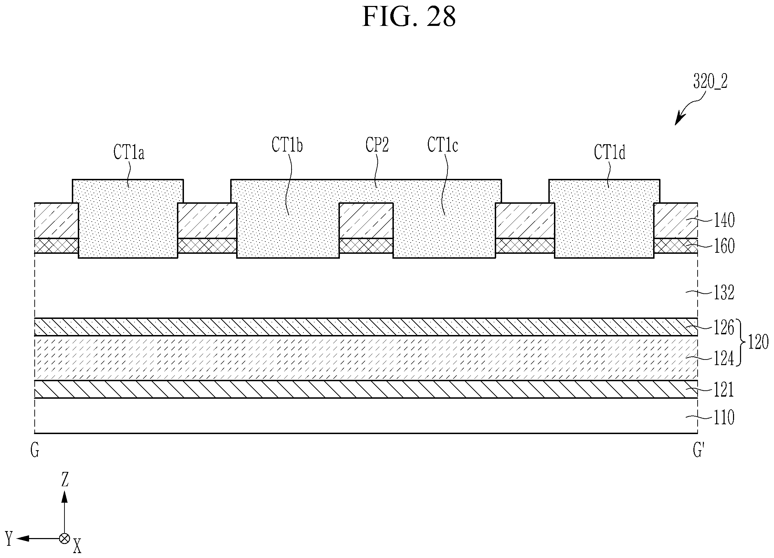

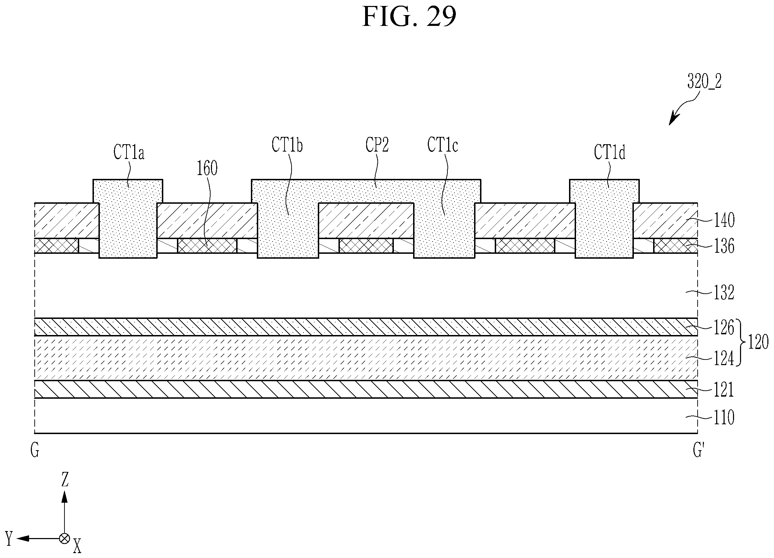

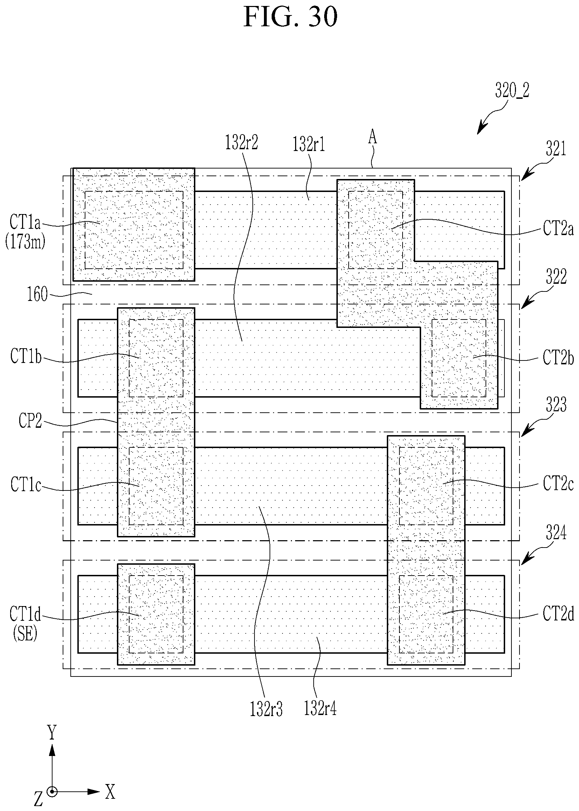

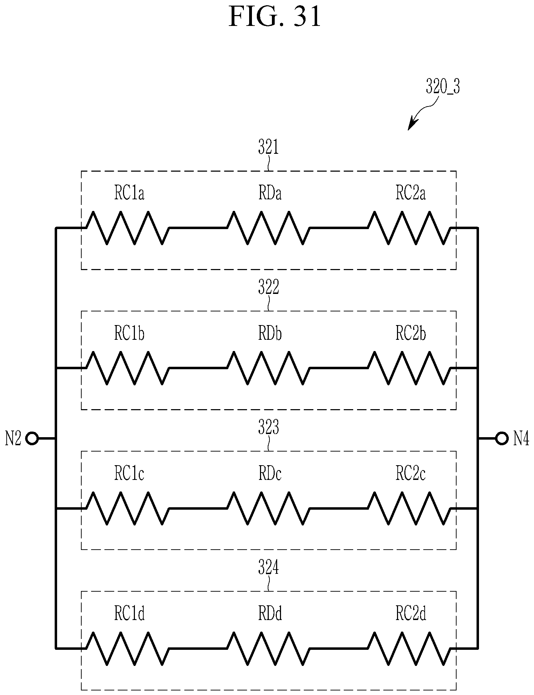

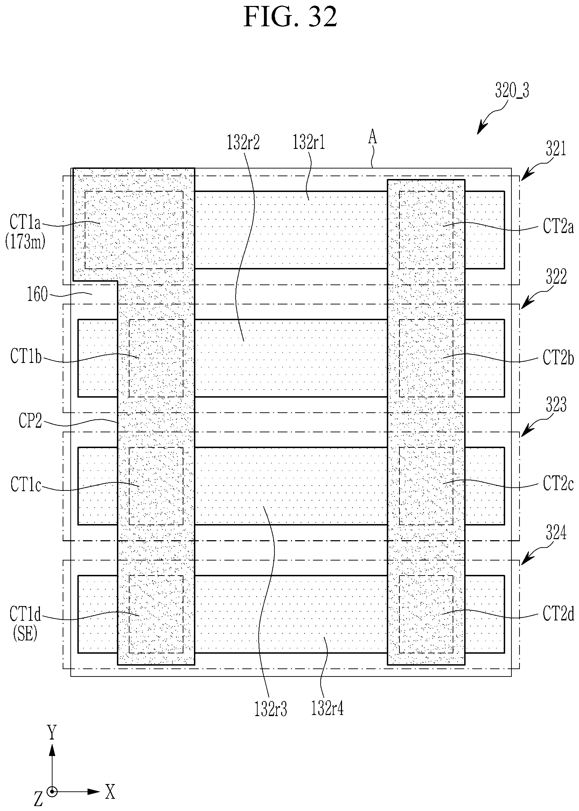

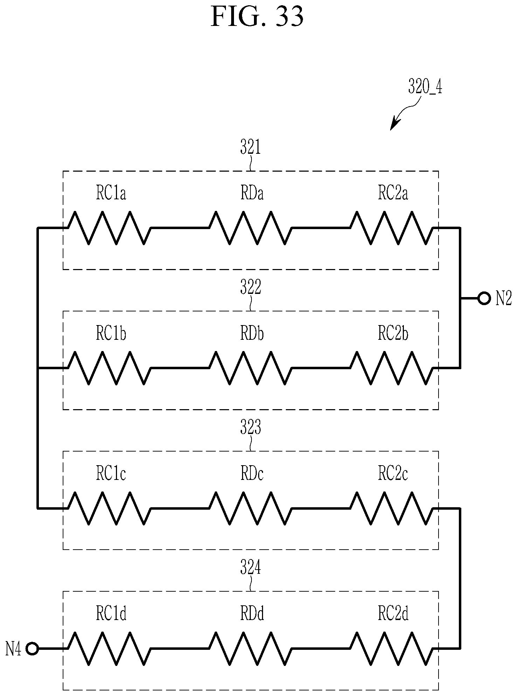

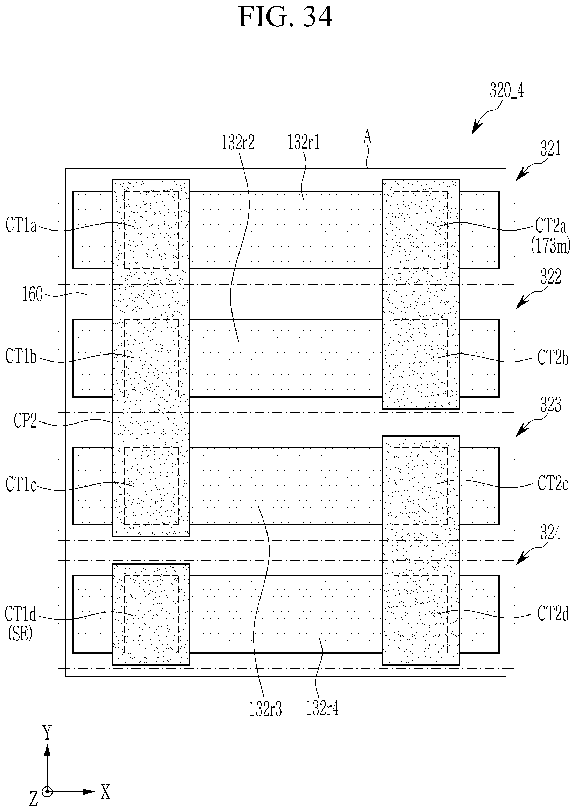

FIG. 25 is a circuit diagram illustrating a resistive element of a semiconductor device according to some embodiments. FIG. 26 is a plan view illustrating a peripheral circuit element including the resistive element of FIG. 25. FIG. 27 is an enlarged plan view illustrating the resistive element of FIG. 26. FIG. 28 is a cross-sectional view taken along line G-G' of FIG. 27. FIG. 29 is a cross-sectional view which illustrates a resistive element of a semiconductor device according to some embodiments and corresponds to line G-G' of FIG. 27. FIG. 30 is a plan view illustrating a resistive element of a semiconductor devices according to some embodiments. FIG. 31 is a circuit diagram illustrating a resistive element of a semiconductor device according to some embodiments. FIG. 32 is an enlarged plan view illustrating the resistive element of FIG. 31. FIG. 33 is a circuit diagram illustrating a resistive element of a semiconductor device according to some embodiments. FIG. 34 is an enlarged plan view illustrating the resistive element of FIG. 32.

Referring to FIGS. 25 to 34, a resistive element 320_2 of semiconductor device according to some embodiments may include a plurality of resistive elements.

A plurality of resistive elements 321 to 324 may be arranged along one direction. The arrangement direction of the plurality of resistive elements 321 to 324 may be different from the extension direction of channel patterns 132r1 to 132r4 of the respective resistive elements 321 to 324. In other words, the channel pattern 132r1 of the resistive element 321, the channel pattern 132r2 of the resistive element 322, the channel pattern 132r3 of the resistive element 323, and the channel pattern 132r4 of the resistive element 324 may extend in the first direction (the X direction), and the resistive elements 321 to 324 may be arranged along the second direction (the Y direction).

In the embodiments of FIGS. 25 to 34, each of the resistive elements 321 to 324 may correspond to an instance of the resistive element 320 of FIGS. 1 to 11. In other words, the channel pattern 132r1 of the resistive element 321, the channel pattern 132r2 of the resistive element 322, the channel pattern 132r3 of the resistive element 323, and the channel pattern 132r4 of the resistive element 324 may have the same arrangement, shape, structure, material, and the like as those of the channel pattern 132r of FIGS. 1 to 11, and contact electrodes CT1a and CT2a of the resistive element 321, contact electrodes CT1b and CT2b of the resistive element 322, contact electrodes CT1c and CT2c of the resistive element 323, and contact electrodes CT1d and CT2d of the resistive element 324 may have the same arrangement, shape, structure, material, and the like as those of the contact electrodes CT1 and CT2 of FIGS. 1 to 11.

In some embodiments, the respective channel patterns 132r1 to 132r4 of the resistive elements 321 to 324 may have substantially the same length in the first direction (the X direction). As an example, the length between a contact interface of the channel pattern 132r1 that is in contact with the contact electrode CT1a of the resistive element 321 and a contact interface of the channel pattern 132r1 that is in contact with the contact electrode CT2a of the resistive element 321 may be substantially the same as the length between a contact interface of the channel pattern 132r2 that is in contact with the contact electrode CT1b of the resistive element 322 and a contact interface of the channel pattern 132r2 that is in contact with the contact electrode CT2b of the resistive element 322. In other words, the length in the first direction (the X direction) of the channel pattern 132r1 between the contact electrode CT1a and contact electrode CT2a of the resistive element 321 may be substantially the same as the length in the first direction (the X direction) of the channel pattern 132r2 between the contact electrode CT1b and contact electrode CT2b of the resistive element 322. The same may be true for the resistive element 323 and the resistive element 324.

However, the present disclosure is not limited thereto, and the respective channel patterns 132r1 to 132r4 of the resistive elements 321 to 324 may have different lengths in the second direction (the Y direction).

In some embodiments, the width of each of the plurality of contact electrodes CT1a, CT1b, CT1c, and CT1d and CT2a, CT2b, CT2c, and CT2d may be larger than the width of the channel patterns 132r1 to 132r4. For example, as shown in FIGS. 27 and 28, the maximum width of each of the plurality of contact electrodes CT1a, CT1b, CT1c, and CT1d and CT2a, CT2b, CT2c, and CT2d in the second direction (the Y direction) may be larger than the width of the channel patterns 132r1 to 132r4 in the second direction (the Y direction). In some embodiments, the width in the second direction (the Y direction) of portions of the plurality of contact electrodes CT1a, CT1b, CT1c, and CT1d and CT2a, CT2b, CT2c, and CT2d, positioned inside spaces formed by recessing at least some portions of the channel patterns 132r1 to 132r4, may be substantially the same as the width of the channel patterns 132r1 to 132r4 in the second direction (the Y direction), and the width in the second direction (the Y direction) of portions of the plurality of contact electrodes CT1a, CT1b, CT1c, and CT1d and CT2a, CT2b, CT2c, and CT2d, protruding from the upper surfaces of the channel patterns 132r1 to 132r4, may be larger than the width of the channel patterns 132r1 to 132r4 in the second direction (the Y direction). Accordingly, at least some portions of the plurality of contact electrodes CT1a, CT1b, CT1c, and CT1d and CT2a, CT2b, CT2c, and CT2d may overlap the separation structure 160 in the third direction (the Z direction).

However, the present disclosure is not limited thereto, and as another example, as shown in FIG. 29, the maximum width of each of the plurality of contact electrodes CT1a, CT1b, CT1c, and CT1d and CT2a, CT2b, CT2c, and CT2d in the second direction (the Y direction) may be substantially smaller than or equal to the width of the channel patterns 132r1 to 132r4 in the second direction (the Y direction). In this case, between the plurality of contact electrodes CT1a, CT1b, CT1c, and CT1d and CT2a, CT2b, CT2c, and CT2d adjacent in the second direction (the Y direction), the barrier layer 136 may be further positioned. In other words, the separation structure 160 may be positioned between the plurality of contact electrodes CT1a, CT1b, CT1c, and CT1d and CT2a, CT2b, CT2c, and CT2d adjacent in the second direction (the Y direction), and the barrier layer 136 may be positioned between the plurality of contact electrodes CT1a, CT1b, CT1c, and CT1d and CT2a, CT2b, CT2c, and CT2d and the separation structure 160. As an example, between the contact electrode CT1a of the resistive element 321 and the separation structure 160 and between the contact electrode CT1b of the resistive element 322 and the separation structure 160, the barrier layer 136 may be further positioned. Accordingly, the separation structure 160 may be positioned apart from the contact electrode CT1a of the resistive element 321 and the contact electrode CT1b of the resistive element 322 in the second direction (the Y direction). Further, the plurality of contact electrodes CT1a, CT1b, CT1c, and CT1d and CT2a, CT2b, CT2c, and CT2d may not overlap the separation structure 160 in the third direction (the Z direction), and at least some portions of the plurality of contact electrodes CT1a, CT1b, CT1c, and CT1d and CT2a, CT2b, CT2c, and CT2d may overlap the barrier layer 136 in the third direction (the Z direction), however, the present disclosure is not limited thereto.

In some embodiments, the plurality of resistive elements 321 to 324 may be separated by the separation structure 160. For example, the separation structure 160 may be positioned in parallel with the channel pattern 132r, and the plurality of channel patterns 132r1 to 132r4 may be separated by the separation structure 160. In some embodiments, the separation structure 160 may recess at least some portions of the channel pattern 132r, however, the present disclosure is not limited thereto. For example, the separation structure 160 may completely pass through the channel pattern 132r so as to be in contact with the protective layer 140. As another example, the separation structure 160 may not pass through the channel pattern 132r. In other words, the lower surface of the separation structure 160 may be positioned substantially at a level with the lower surface of the barrier layer 136. The separation structure 160 may be formed by forming the barrier layer 136 on the main channel layer 132m and the channel pattern 132r and performing a process of implanting ions into the barrier layer 136 positioned between the plurality of resistive elements 321 to 324.

In some embodiments, the separation structure 160 may be formed by forming the barrier layer 136 on the main channel layer 132m and the channel pattern 132r and performing a process of implanting ions into the barrier layer 136 positioned between the main transistor 100 and the resistive element 320_2. However, the present disclosure is not limited thereto, and the separation structure 160 may be formed by forming the barrier layer 136 on the main channel layer 132m and the channel pattern 132r, forming trenches so as to pass through the barrier layer 136, and filling the trenches with an insulating material. The insulating material constituting the separation structure 160 may be formed of the same material as that of the protective layer 140. For example, the insulating material constituting the separation structure 160 may contain an oxide such as $SiO_2$, $Al_2O_3$, etc. As another example, the insulating material constituting the separation structure 160 may contain a nitride such as SiN, or an oxynitride such as SiON. However, the insulating material constituting the separation structure 160 is not limited thereto, and may contain a material different from that of the protective layer 140. In this case, at least a portion of at least one of the main channel layer 132m and the channel pattern 132r may be recessed as well.

In some embodiments, each of the plurality of resistive elements 321 to 324 may have a resistance component. For example, the resistance of the resistive element 321 may include the first contact resistance RC1a of the resistive element 321, the drift region resistance RDa, and the second contact resistance RC2a of the resistive element 321, and the resistance of the resistive element 322 may include the first contact resistance RC1b of the resistive element 322, the drift region resistance RDb, and the second contact resistance RC2b of the resistive element 322. Further, the resistance of the resistive element 323 may include a first contact resistance RC1c of the resistive element 323, a drift region resistance RDc associated with a drift region of the resistive element 323, and a second contact resistance RC2c of the resistive element 323, and the resistance of the resistive element 324 may include a first contact resistance RC1d of the resistive element 324, a drift region resistance RDd associated with a drift region of the resistive element 324, and a second contact resistance RC2d of the resistive element 324.

The plurality of resistive elements 321 to 324 may be electrically connected to one another.

For example, referring to FIGS. 25 to 29, the plurality of resistive elements 321 to 324 may be connected in series. Accordingly, the resistance value of the resistive element 320_2 of the semiconductor device may be the sum of the resistance value of the resistive element 321 to the resistance value of the resistive element 324. As an example, the contact electrode CT1a of the resistive element 321 may include the main source electrode 173m as the node N2, and the contact electrode CT2a of the resistive element 321 and the contact electrode CT2b of the resistive element 322 may be electrically connected, and the contact electrode CT1b of the resistive element 322 and the contact electrode CT1c of the resistive element 323 may be electrically connected, and the contact electrode CT2c of the resistive element 323 and the contact electrode CT2d of the resistive element 324 may be electrically connected, and the contact electrode CT1d of the resistive element 324 may include the sensing electrode SE as the node N4, however, the present disclosure is not limited thereto. Although it has been described that in some embodiments, the contact electrode CT1a of the resistive element 321 corresponds to the main source electrode 173m, the present disclosure is not limited thereto. For example, the contact electrode CT1a of the resistive element 321 may be electrically connected to the main source electrode 173m through a separate electrode.

In some embodiments, the contact electrode CT2a of the resistive element 321 and the contact electrode CT2b of the resistive element 322 may be integrally formed. In other words, the contact electrode CT2a of the resistive element 321 and the contact electrode CT2b of the resistive element 322 may be integrally formed in the same process. In this case, a connection portion CP1, which connects the contact electrode CT2a of the resistive element 321 and the contact electrode CT2b of the resistive element 322, may overlap the separation structure 160 and the protective layer 140 in the third direction (the Z direction). The connection portion CP1 may cover the upper surface of the protective layer 140.

The same may be true for the relationship between the contact electrode CT1b of the resistive element 322 and the contact electrode CT1c of the resistive element 323 and for the relationship between the contact electrode CT2c of the resistive element 323 and the contact electrode CT2d of the resistive element 324. In other words, the contact electrode CT1b of the resistive element 322 and the contact electrode CT1c of the resistive element 323 may be integrally formed. Also, the contact electrode CT2c of the resistive element 323 and the contact electrode CT2d of the resistive element 324 may be integrally formed. In this case, a connection portion CP2 that connects the contact electrode CT1b of the resistive element 322 and the contact electrode CT1c of the resistive element 323, and a connection portion CP3 that connects the contact electrode CT2c of the resistive element 323 and the contact electrode CT2d of the resistive element 324 may overlap the separation structure 160 and the protective layer 140 in the third direction (the Z direction).

Hereinafter, a plurality of contact electrodes integrally formed will be referred to as a contact group. In other words, in some embodiments, the contact electrode CT2a of the resistive element 321, the contact electrode CT2b of the resistive element 322, and the connection portion CP1 may be referred to as a first contact group, and the contact electrode CT1b of the resistive element 322, the contact electrode CT1c of the resistive element 323, and the connection portion CP2 may be referred to as a second contact group, and the contact electrode CT2c of the resistive element 323, the contact electrode CT2d of the resistive element 324, and the connection portion CP3 may be referred to as a third contact group. In some embodiments, the plurality of contact groups may be alternately positioned on opposite sides of the channel pattern 132r on a plane. For example, on a plane defined by the first direction (the X direction) and the second direction (the Y direction), the first contact group may be positioned on one side of the channel pattern 132r1 and one side of the channel pattern 132r2, and the second contact group may be positioned on the other side of the channel pattern 132r2 and the other side of the channel pattern 132r3. Further, the third contact group may be positioned on one side of the channel pattern 132r3 and one side of the channel pattern 132r4, however, the present disclosure is not limited thereto. Accordingly, the resistive elements 321 to 324 may be connected in series.

In FIGS. 27 to 29, it is shown that at least some of the plurality of contact electrodes CT1a, CT1b, CT1c, and CT1d and CT2a, CT2b, CT2c, and CT2d are integrally formed through the connection portions CP1 to CP3, however, the present disclosure is not limited thereto. For example, after the plurality of contact electrodes CT1a, CT1b, CT1c, and CT1d and CT2a, CT2b, CT2c, and CT2d is formed first, the connection portions may be separately formed. As another example, after the plurality of contact electrodes CT1a, CT1b, CT1c, and CT1d and CT2a, CT2b, CT2c, and CT2d is formed and an insulating layer is formed so as to cover the plurality of contact electrodes CT1a, CT1b, CT1c, and CT1d and CT2a, CT2b, CT2c, and CT2d, electrodes may be formed so as to pass through the insulating layer. In this case, through the above-mentioned electrodes that pass through the insulating layer and are electrically connected to the plurality of contact electrodes CT1a, CT1b, CT1c, and CT1d and CT2a, CT2b, CT2c, and CT2d, at least some of the plurality of contact electrodes CT1a, CT1b, CT1c, and CT1d and CT2a, CT2b, CT2c, and CT2d may be electrically connected.

In some embodiments, each of the resistive elements 321 to 324 may have a substantially constant resistance value regardless of the temperature. In such embodiments, since each of the resistive elements 321 to 324 has a substantially constant resistance value regardless of the temperature, regardless of how the resistive elements 321 to 324 are arranged, the resistive element 320_2 of the semiconductor device may have a substantially constant resistance value regardless of the temperature. Therefore, by connecting the resistive elements 321 to 324 in various ways without need for consideration of a change in resistance value according to temperature, it is possible to easily design elements having substantially constant resistance values regardless of the temperature.

However, the present disclosure is not limited thereto, and at least some of the resistive elements 321 to 324 may have positive temperature coefficients of resistance (TCRs), and others may have negative temperature coefficients of resistance (TCRs). Even in this case, the total resistance of the resistive elements 321 to 324 may have a substantially constant resistance value regardless of the temperature. For example, as shown in FIG. 30, the resistive element 321 may have a negative temperature coefficient of resistance (TCR), and the resistive element 322 may have a positive temperature coefficient of resistance (TCR). In this case, the resistive element 323 and the resistive element 324 may have substantially constant resistance values regardless of the temperature. Specifically, the length of the channel pattern 132r1 of the resistive element 321 in the first direction (the X direction) may be shorter than the length of the channel pattern 132r3 of the resistive element 323 in the first direction (the X direction). Accordingly, the resistance of the resistive element 321 may be less affected by a resistance component due to the drift region of the channel pattern 132r1, and the resistance of the resistive element 321 may have a negative temperature coefficient of resistance (TCR). Also, the length of the channel pattern 132r2 of the resistive element 322 in the first direction (the X direction) may be longer than the length of the channel pattern 132r3 of the resistive element 323 in the first direction (the X direction). Accordingly, the resistance of the resistive element 323 may be more affected by a resistance component due to the drift region of the channel pattern 132r3, and the resistance of the resistive element 323 may have a positive temperature coefficient of resistance (TCR). Even in this case, the sum of the resistance of the resistive element 321 and the resistance of the resistive element 322 may have a substantially constant resistance value regardless of the temperature. As another example, in some embodiments, the resistive element 324 may further include an intermediate contact electrode between the contact electrode CT1d and the contact electrode CT2d.

As a further example, as shown in FIGS. 31 and 32, the plurality of resistive elements 321 to 324 may be connected in parallel.

The contact electrode CT1a of the resistive element 321, the contact electrode CT1b of the resistive element 322, the contact electrode CT1c of the resistive element 323, and the contact electrode CT1d of the resistive element 324 may be electrically connected to the main source electrode 173m as the node N2, and the contact electrode CT2a of the resistive element 321, the contact electrode CT2b of the resistive element 322, the contact electrode CT2c of the resistive element 323, and the contact electrode CT2d of the resistive element 324 may be electrically connected to the sensing electrode SE as the node N4. In this case, the contact electrode CT1a of the resistive element 321 may include the main source electrode 173m, and the contact electrode CT2d of the resistive element 324 may include the sensing electrode SE, however, the present disclosure is not limited thereto.

In some embodiments, the contact electrode CT1a of the resistive element 321, the contact electrode CT1b of the resistive element 322, the contact electrode CT1c of the resistive element 323, and the contact electrode CT1d of the resistive element 324 may be integrally formed. In other words, the contact electrode CT1a of the resistive element 321, the contact electrode CT1b of the resistive element 322, the contact electrode CT1c of the resistive element 323, and the contact electrode CT1d of the resistive element 324 may be integrally formed in the same process. In this case, the contact electrode CT1a of the resistive element 321 and the contact electrode CT1b of the resistive element 322, the contact electrode CT1b of the resistive element 322 and the contact electrode CT1c of the resistive element 323, and the contact electrode CT1c of the resistive element 323 and the contact electrode CT1d of the resistive element 324 may be connected by connection portions. The connection portions may overlap the separation structure 160 and the protective layer 140 in the third direction (the Z direction). The connection portions may cover the upper surface of the protective layer 140.

Also, the contact electrode CT2a of the resistive element 321, the contact electrode CT2b of the resistive element 322, the contact electrode CT2c of the resistive element 323, and the contact electrode CT2d of the resistive element 324 may be integrally formed. In other words, the contact electrode CT2a of the resistive element 321, the contact electrode CT2b of the resistive element 322, the contact electrode CT2c of the resistive element 323, and the contact electrode CT2d of the resistive element 324 may be integrally formed in the same process. In this case, the contact electrode CT2a of the resistive element 321 and the contact electrode CT2b of the resistive element 322, the contact electrode CT2b of the resistive element 322 and the contact electrode CT2c of the resistive element 323, and the contact electrode CT2c of the resistive element 323 and the contact electrode CT2d of the resistive element 324 may be connected by connection portions. The connection portions may overlap the separation structure 160 and the protective layer 140 in the third direction (the Z direction). The connection portions may cover the upper surface of the protective layer 140.

In FIG. 32, it is shown that the plurality of contact electrodes CT1a, CT1b, CT1c, and CT1d and CT2a, CT2b, CT2c, and CT2d is formed integrally with the connection portions, however, the present disclosure is not limited thereto. For example, after the plurality of contact electrodes CT1a, CT1b, CT1c, and CT1d and CT2a, CT2b, CT2c, and CT2d is formed first, the connection portions may be separately formed. As another example, after the plurality of contact electrodes CT1a, CT1b, CT1c, and CT1d and CT2a, CT2b, CT2c, and CT2d is formed and an insulating layer is formed so as to cover the plurality of contact electrodes CT1a, CT1b, CT1c, and CT1d and CT2a, CT2b, CT2c, and CT2d, electrodes may be formed so as to pass through the insulating layer.

In some embodiments, the resistive element 321 to the resistive element 324 may have substantially constant resistance values regardless of the temperature Accordingly, regardless of how the resistive elements 321 to 324 are arranged, the resistive element 320_2 of the semiconductor device may have a substantially constant resistance value regardless of the temperature. Therefore, by connecting the resistive elements 321 to 324 in various ways, it may be possible to easily design elements having substantially constant resistance values regardless of the temperature.

In some embodiments, the resistive elements 321 to 324 may be connected in series (as illustrated in FIG. 25) or may be connected in parallel (as illustrated in FIG. 31). However, the present disclosure is not limited thereto, and various combinations and changes are possible. In some embodiments, some of the resistive elements 321 to 324 may be connected in series, and others may be connected in parallel. For example, as shown in FIG. 33, the resistive element 321 and the resistive element 322 may be connected in parallel, and the resistive element 323 and the resistive element 324 may be connected in series with the resistive element 321. In this example, the contact electrode CT2a of the resistive element 321 and the contact electrode CT2b of the resistive element 322 may be electrically connected to the main source electrode 173m as the node N2, and the contact electrode CT1a of the resistive element 321 and the contact electrode CT1b of the resistive element 322 may be electrically connected to the contact electrode CT1c of the resistive element 323, and the contact electrode CT2c of the resistive element 323 and the contact electrode CT2d of the resistive element 324 may be electrically connected, and the contact electrode CT1d of the resistive element 324 may be electrically connected to the sensing electrode SE as the node N4. In some embodiments, the contact electrode CT2a of the resistive element 321 may include the main source electrode 173m, and the contact electrode CT1d of the resistive element 324 may include the sensing electrode SE, however, the present disclosure is not limited thereto.

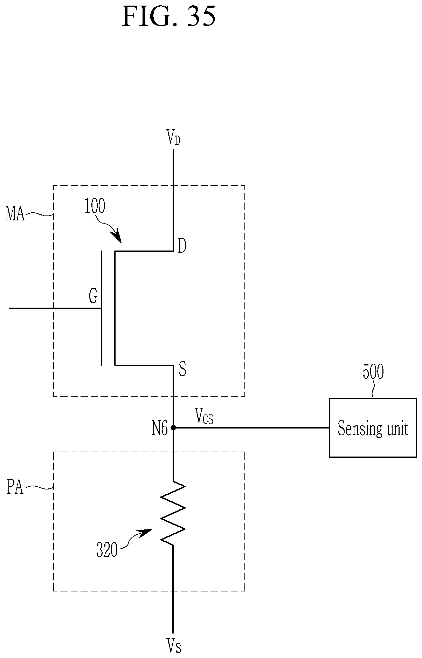

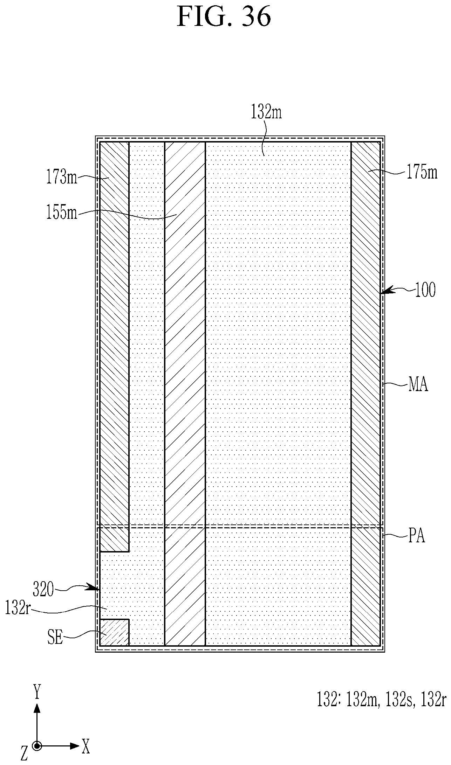

Hereinafter, a semiconductor device according to some embodiments will be described with reference to FIGS. 35 and 36.

First, referring to FIG. 35, a semiconductor device according to some embodiments may include the main transistor 100 and the resistive element 320, but may not include the sub transistor 310.

To the drain electrode D of the main transistor 100, the power voltage $V_D$ may be supplied, and the source electrode S of the main transistor 100 may be electrically connected to the resistive element 320 through a node N6. Also, the source electrode S of the main transistor 100 may be electrically connected to the sensing unit 500 through the node N6.

The resistive element 320 may be electrically connected to the source electrode S of the main transistor 100 through the node N6. In other words, one end of the resistive element 320 may be electrically connected to the main source electrode (reference symbol "173m" in FIG. 36) of the main transistor 100 through the node N6. Also, the one end of the resistive element 320 may be electrically connected to the sensing unit 500 through the node N6. The other end of the resistive element 320 may be connected to a power source having the power voltage Vs. Accordingly, the power voltage Vs may be supplied to the other end of the resistive element 320. The power voltage Vs may be, for example, a ground voltage.

Accordingly, when the main transistor 100 is turned on, current can flow from the drain electrode D of the main transistor 100 to the source electrode S, and can flow in the resistive element 320 through the node N6. At this time, in the resistive element 320, a voltage drop may occur in proportion to the magnitude of the current flowing through the main transistor 100. In other words, the sensing voltage Vcs of the node N6 may be determined in proportion to the magnitude of the current flowing through the main transistor 100.

Therefore, the sensing unit 500 may calculate the magnitude of the current flowing in the main transistor 100 on the basis of the magnitude of the sensing voltage $V_{CS}$ sensed. In other words, when a sensing voltage Vcs in a range greater than sensing voltages $V_{CS}$ in the pre-stored range is detected, the sensing unit 500 may detect an overcurrent condition in the main transistor 100.

Referring to FIG. 36, the main drain electrode 175m of the semiconductor device according to some embodiments may correspond to the drain electrode D of the main transistor 100 of FIG. 35, and the main gate electrode 155m may correspond to the gate electrode G of the main transistor 100 of FIG. 35, and the main source electrode 173m may correspond to the source electrode S of the main transistor 100 of FIG. 35. Further, the sensing electrode SE may be a point corresponding to the node N6 of FIG. 35.

In some embodiments, in the semiconductor device of FIGS. 35 and 36, the separation structure 160 (discussed above in reference to FIG. 2) may be omitted, such that it is not present between the main element area MA and the peripheral circuit area PA. In some embodiments, the main channel layer 132m may be positioned in the main element area MA and the peripheral circuit area PA. The main channel layer 132m may extend in the second direction (the Y direction) from one side of the main element area MA in the second direction (the Y direction) to the other side, and from one side of the peripheral circuit area PA in the second direction (the Y direction) to the other side.

In some embodiments, the main drain electrode 175m, the main gate electrode 155m, and the main source electrode 173m may extend along the second direction (the Y direction). For example, the main drain electrode 175m and the main gate electrode 155m may extend in the second direction (the Y direction) from one side of the main element area MA in the second direction (the Y direction) to the other side, and from one side of the peripheral circuit area PA in the second direction (the Y direction) to the other side. The main source electrode 173m may extend in the second direction (the Y direction) from one side of the main element area MA in the second direction (the Y direction) to the other side, so as to pass through at least a portion of the peripheral circuit area PA. The length of the main source electrode 173m in the second direction (the Y direction) may be shorter than the length of the main drain electrode 175m in the second direction (the Y direction) and the length of the main gate electrode 155m in the second direction (the Y direction).

In some embodiments, the channel pattern 132r may be positioned between the sensing electrode SE and the main source electrode 173m. The channel pattern 132r may refer to a portion of the main channel layer 132m positioned between the sensing electrode SE and the main source electrode 173m. In other words, the channel pattern 132r and the main channel layer 132m may be integrally formed. A description of this is substantially identical to the description of the embodiment of FIGS. 1 to 11, and thus will not be made.

In the peripheral circuit area PA, the separation structure may be not positioned between the main source electrode 173m and the main gate electrode 155m. In other words, the main channel layer 132m and the barrier layer 136 may be positioned between the main source electrode 173m and the main gate electrode 155m. Also, the separation structure may be not positioned between the channel pattern 132r and the main channel layer 132m. However, the present disclosure is not limited thereto, and for example, in the peripheral circuit area PA, the separation structure may be positioned between the main source electrode 173m and the main gate electrode 155m and between the channel pattern 132r and the main channel layer 132m.

In some embodiments, the channel pattern 132r may include the resistance of the sub drift region DTRs2. In this case, the resistance of the sub drift region DTRs2 may have a positive temperature coefficient of resistance (TCR).

In some embodiments, the contact resistance RC1 and the contact resistance RC2 may have different values depending on the temperature. For example, the contact resistance RC1 and the contact resistance RC2 may decrease as the temperature rises. Also, the resistance of the contact interface between the sensing electrode SE and the channel pattern 132r and the resistance of the contact interface between the main source electrode 173m and the channel pattern 132r may have negative temperature coefficients of resistance (TCRs).

**Claims**

1.   A semiconductor device comprising:

a main transistor (100);
a sub transistor (310) that is connected to one terminal of the main transistor (100); and
a resistive element (320) that is connected between another terminal of the main transistor (100) and the sub transistor (310);
wherein the semiconductor device includes a channel layer (132);
wherein the main transistor (100) includes:

a main channel layer (132m) comprising a first portion of the channel layer (132) of the semiconductor device;
a barrier layer (136) that is positioned on the main channel layer (132m) and contains a material having an energy band gap different from an energy band gap of the main channel layer (132m);
a main gate electrode (155m) that is positioned on the barrier layer (136);
a gate semiconductor layer (152m, 152s) that is positioned between the barrier layer (136) and the main gate electrode (155m); and
a main source electrode (173m) and a main drain electrode (175m) that are positioned on opposite sides of the main gate electrode (155m) and are connected to the main channel layer (132m), and

wherein the sub transistor (310) includes:

a sub channel layer (132s) comprising a second portion of the channel layer (132) of the semiconductor device, wherein the sub channel layer (132s) includes a first sub drift region (DTRs1) having a first 2-dimensional electron gas, 2DEG, region (134m);
a sub drain electrode (175s) that is connected to the sub channel layer (132s) and extends from one end of the main drain electrode (175m);
a sub gate electrode (155s) that is positioned on the sub channel layer (132s); and
a sensing electrode (SE) that is positioned on the sub channel layer (132s) and is positioned on one side of the sub gate electrode (155s),
wherein a width (W2) of the sub channel layer (132s) is different from a width (W1) of the main channel layer (132m), and

wherein the resistive element (320) includes a channel pattern (132r) comprising a third portion of the channel layer (132) of the semiconductor device, the resistive element (320) being electrically connected between the sensing electrode (SE) and the main source electrode (173m) and including a second sub drift region (DTRs2) having a second 2DEG region (134r).

2. The semiconductor device of claim 1, wherein:

a resistance of the second sub drift region (DTRs2) has a positive temperature coefficient of resistance,
a first contact resistance (RC1) between the sensing electrode (SE) and the channel pattern (132r) and a second contact resistance (RC2) between the main source electrode (173m) and the channel pattern (132r) have negative temperature coefficients of resistance, and
a sum of the resistance of the second sub drift region (DTRs2), the first contact resistance (RC1), and the second contact resistance (RC2) is substantially constant regardless of temperature.

3. The semiconductor device of claim 1 or 2, wherein:
the width (W2) of the sub channel layer (132s) is smaller than the width (W1) of the main channel layer (132m).

4. The semiconductor device of any one of claims 1 to 3, wherein:

the main drain electrode (175m) and the sub drain electrode (175s) extend in a first direction (Y), and
the channel pattern (132r) includes a portion extending in the first direction (Y).

5. The semiconductor device of claim 4, wherein:
a width (W4) of the channel pattern (132r) in a second direction (X) intersecting with the first direction (Y) is the same as a width of the main source electrode (173m) in the second direction (X).

6. The semiconductor device of claim 4 or 5, wherein:
a length (LT) in the first direction (Y) of the channel pattern (132r) between the sensing electrode (SE) and the main source electrode (173m) is 1 μm to 10 μm.

7. The semiconductor device of claim 6, wherein:
the length (LT) in the first direction (Y) of the channel pattern (132r) between the sensing electrode (SE) and the main source electrode (173m) is 3 μm to 4 μm.

8. The semiconductor device of any one of claims 1 to 7, wherein:
the channel pattern (132r) is positioned together with the main channel layer (132m) and the sub channel layer (132s) in the same layer, and the channel pattern (132r) is formed of the same material as the main channel layer (132m) and the sub channel layer (132s).

9. The semiconductor device of any one of claims 1 to 8, wherein:
the barrier layer (136) is further positioned on the sub channel layer (132s) and the channel pattern (132r).

10. The semiconductor device of claim 9, wherein:

the sub gate electrode (155s) is formed integrally with the main gate electrode (155m), and
the sub drain electrode (175s) is formed integrally with the main drain electrode (175m).

11. The semiconductor device of claim 9 or 10, wherein:
the gate semiconductor layer (152m, 152s) is further positioned between the barrier layer (136) and the sub gate electrode (155s).

12. The semiconductor device of any one of claims 1 to 11, further comprising:
a separation structure (160) that is positioned between the resistive element (320) and the sub transistor (310) and passes through the barrier layer (136).

13. The semiconductor device of any one of claims 1 to 12, wherein:
the resistive element (320) further includes a contact electrode (CT) that is positioned on the channel pattern (132r) and is positioned between the sensing electrode (SE) and the main source electrode (173m).

14. The semiconductor device of claim 13, wherein:

the resistive element (320) includes:

a first resistive element (321) that includes a first channel pattern (132r1) positioned between the main source electrode (173m) and the contact electrode (CT); and
a second resistive element (322) that includes a second channel pattern (132r2) positioned between the contact electrode (CT) and the sensing electrode (SE), and

a length of the first channel pattern (132r1) is the same as a length of the second channel pattern (132r2).

15. The semiconductor device of claim 14, wherein:
the first channel pattern (132r1) is formed of the same material as the second channel pattern (132r2).

# FIG. 1

# FIG. 2

132: 132m, 132s, 132r
155: 155m, 155s
175: 175m, 175s
300: 310, 320

# FIG. 3

EP 4 622 419 A1

# FIG. 4

EP 4 622 419 A1

# FIG. 5

# FIG. 6

EP 4 622 419 A1

# FIG. 7

EP 4 622 419 A1

FIG. 8

# FIG. 9

EP 4 622 419 A1

# FIG. 10

EP 4 622 419 A1

# FIG. 11

RV

RV1_U

RV2

RV1_U [Ω/um]

RV, RV2 [Ω]

T [℃]

41

# FIG. 12

# FIG. 13

# FIG. 14

# FIG. 15

300: 310, 320

# FIG. 16

# FIG. 17

# FIG. 18

# FIG. 19

FIG. 20

EP 4 622 419 A1

320_1

321

322

RC1a    RDa    RC2a    RC1b    RDb    RC2b

N2    N4

# FIG. 21

132r: 132r1, 132r2
300: 310, 320_1

# FIG. 22

EP 4 622 419 A1

# FIG. 23

132r: 132r1, 132r2
300: 310, 320_1

# FIG. 24

320_1

173m    CI2  CI3    CT1    160    CP    CT2    CI4  CI1    SE

140
136

132r1    132r2

126 } 120
124 }

121
110

F                                                      F'

Z
Y⊗ → X

DTR1        DTR2

132r: 132r1, 132r2

EP 4 622 419 A1

# FIG. 25

320_2

321

| RC1a | RDa | RC2a |

N2

322

| RC1b | RDb | RC2b |

323

| RC1c | RDc | RC2c |

324

| RC1d | RDd | RC2d |

N4

# FIG. 26

300: 310, 320_2

# FIG. 27

# FIG. 28

320_2

CT1a    CT1b    CP2    CT1c    CT1d

140
160
132
126 ⎤
124 ⎦ 120
121
110

G                                                                      G'

EP 4 622 419 A1

# FIG. 29

320_2

CT1a   160   CT1b   CP2   CT1c   CT1d

140
136
132
126
124
120
121
110

G   G'

# FIG. 30

# FIG. 31

320_3

321

RC1a          RDa          RC2a

322

RC1b          RDb          RC2b

N2

323

RC1c          RDc          RC2c

N4

324

RC1d          RDd          RC2d

# FIG. 32

# FIG. 33

320_4

321

RC1a       RDa        RC2a

322

RC1b       RDb        RC2b

○ N2

323

RC1c       RDc        RC2c

324

RC1d       RDd        RC2d

N4 ○

# FIG. 34

# FIG. 35

# FIG. 36

132m

173m

155m

175m

100

MA

PA

320

132r

SE

Y

Z · → X

132: 132m, 132s, 132r

Europäisches
Patentamt

European
Patent Office

Office européen
des brevets

## EUROPEAN SEARCH REPORT

**Application Number**

EP 25 15 4608

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/357907 A1 (UDREA FLORIN [GB] ET AL) 12 November 2020 (2020-11-12) * figures 1, 3-5, 13 and correlated text * ----- | 1-15 | INV. H10D84/80 H10D30/47 H10D1/40 |
| X | US 2023/290871 A1 (SUGIYAMA TORU [JP] ET AL) 14 September 2023 (2023-09-14) * figures 1-3 and correlated text * ----- | 1-11, 13-15 | ADD. H10D64/23 H10D62/17 H10D62/85 |

TECHNICAL FIELDS SEARCHED (IPC)

H10D

The present search report has been drawn up for all claims

| Place of search | Date of completion of the search | Examiner |
|---|---|---|
| Munich | 15 July 2025 | Moehl, Sebastian |

EPO FORM 1503 03.82 (P04C01)

## ANNEX TO THE EUROPEAN SEARCH REPORT
## ON EUROPEAN PATENT APPLICATION NO.

EP 25 15 4608

This annex lists the patent family members relating to the patent documents cited in the above-mentioned European search report.
The members are as contained in the European Patent Office EDP file on
The European Patent Office is in no way liable for these particulars which are merely given for the purpose of information.

15-07-2025

| Patent document cited in search report | Publication date | Patent family member(s) | | Publication date |
|---|---|---|---|---|
| US 2020357907 A1 | 12-11-2020 | CN | 114072909 A | 18-02-2022 |
| | | EP | 3966863 A1 | 16-03-2022 |
| | | TW | 202046502 A | 16-12-2020 |
| | | US | 10818786 B1 | 27-10-2020 |
| | | US | 2022208761 A1 | 30-06-2022 |
| | | WO | 2020225359 A1 | 12-11-2020 |
| US 2023290871 A1 | 14-09-2023 | CN | 116779667 A | 19-09-2023 |
| | | JP | 7684922 B2 | 28-05-2025 |
| | | JP | 2023131475 A | 22-09-2023 |
| | | US | 2023290871 A1 | 14-09-2023 |

EPO FORM P0459

For more details about this annex : see Official Journal of the European Patent Office, No. 12/82